# EUROPEAN PATENT SPECIFICATION

(11) **EP 4 451 321 B1**
(45) Date of publication and mention of the grant of the patent: **09.12.2026**
(21) Application number: 23209985.3
(22) Date of filing: 15.11.2023
(51) Int. Cl.: H10W 20/00, H10W 20/20, H10D 84/03, H10D 84/01

(54) **BACKSIDE CONDUCTIVE STRUCTURES EXTENDING THROUGH INTEGRATED CIRCUIT TO MEET FRONTSIDE CONTACTS**
RÜCKSEITENLEITENDE STRUKTUREN, DIE SICH DURCH EINE INTEGRIERTE SCHALTUNG ERNÄHREN, UM VORDERSEITIGE KONTAKTE ZU ERREICHEN
STRUCTURES CONDUCTRICES ARRIÈRE S'ÉTENDANT À TRAVERS UN CIRCUIT INTÉGRÉ POUR SATISFAIRE DES CONTACTS FRONTAUX

(30) Priority: 21.04.2023 US 202318137731
(43) Date of publication of application: 23.10.2024
(73) Proprietor: INTEL Corporation, Santa Clara, CA 95054 (US)
(72) Inventor: Guler, Leonard, Hillsboro, 97124 (US); Engel, Clifford, Hillsboro, 97123 (US); Nandi, Debaleena, Hillsboro, 97124 (US); Allen, Gary, Portland, 97229 (US); Thomson, Nicholas, Hillsboro, 97124 (US); Acharya, Saurabh, Hillsboro, 97006 (US); Desai, Umang, Portland, 97225 (US); Vishwakarma, Vivek, Hillsboro, 97124 (US); Wallace, Charles, Portland, 97212 (US)
(74) Representative: Goddar, Heinz J.

(56) References cited:
- US-A1- 2020 294 998
- US-A1- 2021 351 303
- US-A1- 2022 310 455
- US-A1- 2022 406 715

## Description

### FIELD OF THE DISCLOSURE

The present disclosure relates to integrated circuits, and more particularly, to through-device contacts.

### BACKGROUND

As integrated circuits continue to scale downward in size, a number of challenges arise. For instance, reducing the size of memory and logic cells is becoming increasingly more difficult, particularly given competing interests in a relatively small amount of space. For instance, routing signal and power throughout the circuit can be challenging given the limited space and density of the devices. Furthermore, electrical isolation between adjacent devices is important to reduce parasitic effects and leakages. Accordingly, there remain a number of non-trivial challenges with respect to the formation of semiconductor devices in memory or logic cells.

US 2022/0406715 A1 discloses a semiconductor device including a hybrid contact scheme for stacked FET with integration of a backside power distribution network (BSPDN). A double-sided (both frontside and backside of the wafer) contact scheme with buried power rail (BPR) and BSPDN provides optimum contact and interconnect. The stacked FET could include, for example, FINFET over FINFET, FINFET over nanosheet, or nanosheet over nanosheet.

US 2021/0351303 A1 relates to capacitance reduction for a back-side power rail device. A semiconductor transistor device includes a channel structure, a gate structure, a first source/drain epitaxial structure, a second source/drain epitaxial structure, a gate contact, and a back-side source/drain contact. The gate structure wraps around the channel structure. The first source/drain epitaxial structure and the second source/drain epitaxial structure are disposed on opposite endings of the channel structure. The gate contact is disposed on the gate structure. The back-side source/drain contact is disposed under the first source/drain epitaxial structure. The first source/drain epitaxial structure has a concave bottom surface contacting the back-side source/drain contact.

US 2022/0310455 A1 relates to a backside via with a low-K spacer. A semiconductor structure and a method of forming the same are provided. In an embodiment, an exemplary method includes forming a fin-shaped structure extending from a front side of a substrate, recessing a source region of the fin-shaped structure to form a source opening, forming a semiconductor plug under the source opening, exposing the semiconductor plug from a back side of the substrate, selectively removing a first portion of the substrate without removing a second portion of the substrate adjacent to the semiconductor plug, forming a backside dielectric layer over a bottom surface of the workpiece, replacing the semiconductor plug with a backside contact, and selectively removing the second portion of the substrate to form a gap between the backside dielectric layer and the backside contact. By forming the gap, a parasitic capacitance between the backside contact and an adjacent gate structure may be advantageously reduced.

US 2020/0294998 A1 discloses backside contacts for semiconductor devices. Backside contact structures include etch selective materials to facilitate backside contact formation. An integrated circuit structure includes a frontside contact region, a device region below the frontside contact region, and a backside contact region below the device region. The device region includes a transistor. The backside contact region includes a first dielectric material under a source or drain region of the transistor, a second dielectric material laterally adjacent to the first dielectric material and under a gate structure of the transistor. A nonconductive spacer is between the first and second dielectric materials. The first and second dielectric materials are selectively etchable with respect to one another and the spacer. The backside contact region may include an interconnect feature that, for instance, passes through the first dielectric material and contacts a bottom side of the source/drain region, and/or passes through the second dielectric material and contacts the gate structure.

### SUMMARY

The present invention is defined by the independent claims. Advantageous embodiments are described by the dependent claims.

### BRIEF DESCRIPTION OF THE DRAWINGS

Figures 1A and 1B are cross-sectional views of an integrated circuit that includes a backside conductive structure that extends upwards to contact one or more frontside contacts, in accordance with an embodiment of the present disclosure.
Figure 1C is a plan view of the integrated circuit of Figures 1A and 1B, in accordance with an embodiment of the present disclosure.
Figures 2A and 2B are cross-sectional views that illustrate a stage in an example process for forming an integrated circuit that has a backside conductive structure that extends upwards to contact one or more frontside contacts, in accordance with some embodiments of the present disclosure.
Figures 3A and 3B are cross-sectional views that illustrate another stage in the example process for forming an integrated circuit that has a backside conductive structure that extends upwards to contact one or more frontside contacts, in accordance with some embodiments of the present disclosure.
Figures 4A and 4B are cross-sectional views that illustrate another stage in the example process for forming an integrated circuit that has a backside conductive structure that extends upwards to contact one or more frontside contacts, in accordance with some embodiments of the present disclosure.
Figures 5A and 5B are cross-sectional views that illustrate another stage in the example process for forming an integrated circuit that has a backside conductive structure that extends upwards to contact one or more frontside contacts, in accordance with some embodiments of the present disclosure.
Figures 6A and 6B are cross-sectional views that illustrate another stage in the example process for forming an integrated circuit that has a backside conductive structure that extends upwards to contact one or more frontside contacts, in accordance with some embodiments of the present disclosure.
Figures 7A and 7B are cross-sectional views that illustrate another stage in the example process for forming an integrated circuit that has a backside conductive structure that extends upwards to contact one or more frontside contacts, in accordance with some embodiments of the present disclosure.
Figures 8A and 8B are cross-sectional views that illustrate another stage in the example process for forming an integrated circuit that has a backside conductive structure that extends upwards to contact one or more frontside contacts, in accordance with some embodiments of the present disclosure.
Figures 9A and 9B are cross-sectional views that illustrate another stage in the example process for forming an integrated circuit that has a backside conductive structure that extends upwards to contact one or more frontside contacts, in accordance with some embodiments of the present disclosure.
Figures 10A and 10B are cross-sectional views that illustrate another stage in the example process for forming an integrated circuit that has a backside conductive structure that extends upwards to contact one or more frontside contacts, in accordance with some embodiments of the present disclosure.
Figures 11A and 11B are cross-sectional views that illustrate another stage in the example process for forming an integrated circuit that has a backside conductive structure that extends upwards to contact one or more frontside contacts, in accordance with some embodiments of the present disclosure.
Figures 12A and 12B are cross-sectional views that illustrate another stage in the example process for forming an integrated circuit that has a backside conductive structure that extends upwards to contact one or more frontside contacts, in accordance with some embodiments of the present disclosure.
Figures 13A and 13B are cross-sectional views that illustrate another stage in the example process for forming an integrated circuit that has a backside conductive structure that extends upwards to contact one or more frontside contacts, in accordance with some embodiments of the present disclosure.
Figures 14A and 14B are cross-sectional views that illustrate another stage in the example process for forming an integrated circuit that has a backside conductive structure that extends upwards to contact one or more frontside contacts, in accordance with some embodiments of the present disclosure.
Figures 15A and 15B are cross-sectional views of another integrated circuit that has a backside conductive structure that extends upwards to contact one or more frontside contacts, in accordance with an embodiment of the present disclosure.
Figure 16 illustrates a cross-sectional view of a chip package containing one or more semiconductor dies, in accordance with some embodiments of the present disclosure.
Figure 17 is a flowchart of a fabrication process for an integrated circuit having a backside conductive structure that extends upwards to contact one or more frontside contacts, in accordance with an embodiment of the present disclosure.
Figure 18 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit that includes one or more backside conductive structures that extend through a device layer of the integrated circuit to contact one or more frontside contacts, such as frontside source or drain contacts. The techniques can be used in any number of integrated circuit applications and are particularly useful with respect to logic and memory cells, such as those cells that use finFETs or gate-all-around transistors (e.g., ribbonFETs and nanowire FETs). In one example, a row of semiconductor devices each include a semiconductor region extending in a first direction between corresponding diffusion regions (e.g., source or drain regions), and a gate structure extending in a second direction through a gate trench over the semiconductor regions of each neighboring semiconductor device along the row. Each semiconductor device may be separated from an adjacent semiconductor device along the second direction by a gate cut. The gate cut may be a dielectric wall that extends through an entire thickness of the gate structure and runs in the first direction between any number of devices. A backside conductive structure may extend through portions of the source or drain regions and also through a portion of one of the dielectric walls within the gate trench to contact one or more frontside contacts on the source or drain regions. One or more backside etching processes may be performed to expose the frontside contacts from the backside of the device, and one or more deposition processes may be subsequently carried out to form the backside conductive structure within the cavity formed by the etching. Numerous variations and embodiments will be apparent in light of this disclosure.

### General Overview

As previously noted above, there remain a number of non-trivial challenges with respect to formation of various semiconductor structures. Power and signal routing can be challenging given the number and density of semiconductor devices on a single die. Power routing may be performed by running large conductive traces on the backside of the die (e.g., after removing the semiconductor substrate). Often in such cases, deep backside vias are used to connect any frontside interconnects with the power traces on the backside of the die. The fabrication of such deep vias is non-trivial and can involve numerous additional masking steps.

Thus, and in accordance with an embodiment of the present disclosure, an integrated circuit is disclosed that includes one or more backside conductive structures to route signal and/or power between frontside contacts and backside contacts or traces. The conductive structures may be formed via one or more etching processes from the backside of the device that expose the underside of one or more of the frontside contacts. Accordingly, various portions of the semiconductor devices are removed from the backside, such as portions of source or drain regions and portions of one or more dielectric walls that extend between devices. In some embodiments, the conductive structures extend through one or more "dummy" or unused semiconductor devices to make a through-device connection between frontside and backside interconnect layers. In some embodiments, the conductive structures extend through portions of the device where semiconductor devices were not formed (e.g. semiconductor fins were removed prior to formation of a gate structure and source or drain regions). In either case, the conductive structures may extend partially through one or more dielectric walls that extend in a grating-like pattern across the integrated circuit to separate adjacent semiconductor devices from one another. The conductive structures may include the same or similar conductive materials as the frontside contacts.

According to an embodiment, an integrated circuit includes a first semiconductor region extending in a first direction from a first source or drain region, a second semiconductor region extending in the first direction from a second source or drain region with the second source or drain region spaced from the first source or drain region in a second direction different from the first direction, a first gate structure around the first semiconductor region and a second gate structure around the second semiconductor region, a dielectric layer beneath the first gate structure and the second gate structure, a dielectric wall between the first semiconductor region and the second semiconductor region and extending in the first direction such that the dielectric wall extends between the first gate structure and the second gate structure, a first contact on a top surface of the first source or drain region and a second contact on a top surface of the second source or drain region, and a conductive structure extending through an entire thickness of the dielectric layer and along an entire thickness of the first source or drain region and the second source or drain region to contact one or both of the first contact and the second contact. A portion of the conductive structure also extends in the first direction between the first gate structure and the second gate structure.

According to another embodiment, an integrated circuit includes a semiconductor device having a semiconductor region extending in a first direction from a source or drain region and a gate electrode around the first semiconductor region with the gate electrode extending in a second direction different from the first direction, a dielectric wall adjacent to the semiconductor device and extending in the first direction through an entire thickness of the gate electrode and adjacent to the source or drain region, a dielectric fill adjacent to the source or drain region along the second direction such that the dielectric wall extends between the source or drain region and the dielectric fill, one or more conductive contacts on a top surface of the dielectric fill, and a conductive structure extending through an entire thickness of the dielectric layer and through an entire thickness of the dielectric fill to contact one or both of the one or more conductive contacts. A portion of the conductive structure also extends in the first direction through a portion of the gate electrode.

According to another embodiment, a method of forming an integrated circuit includes forming a first fin comprising first semiconductor material and a second fin comprising second semiconductor material, the first and second fins extending above a substrate and each extending in a first direction; forming a gate electrode extending over the first semiconductor material and the second semiconductor material in a second direction different from the first direction; forming a first source or drain region at a first end of the first fin; forming a second source or drain region at a first end of the second fin; forming a contact over the first source or drain region and the second source or drain region; forming a recess through the gate electrode between the first fin and the second fin, the recess further extending in the first direction between the first source or drain region and the second source or drain region, wherein the recess splits the gate electrode into a first gate electrode and a second gate electrode and splits the contact into a first contact and a second contact; forming a dielectric wall within the recess; removing the substrate and forming a dielectric layer beneath the first gate electrode and the second gate electrode; recessing a portion of the dielectric wall from a backside of the integrated circuit such that a top surface of the recessed dielectric wall is between the first gate electrode and the second gate electrode; removing exposed portions of the first source or drain region and the second source or drain region from the backside of the integrated circuit such that portions of one or both of the first contact and the second contact are exposed from the backside; and forming a conductive structure within the recessed area from the backside such that the conductive structure contacts one or both of the first contact and the second contact.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of backside conductive structures that extend through portions of semiconductor devices and/or dielectric walls to contact frontside contacts. In some embodiments, a portion of a dielectric wall will extend through a gate electrode while conductive material from the backside conductive contact will be present beneath the portion of the dielectric wall and also extend through the gate electrode.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

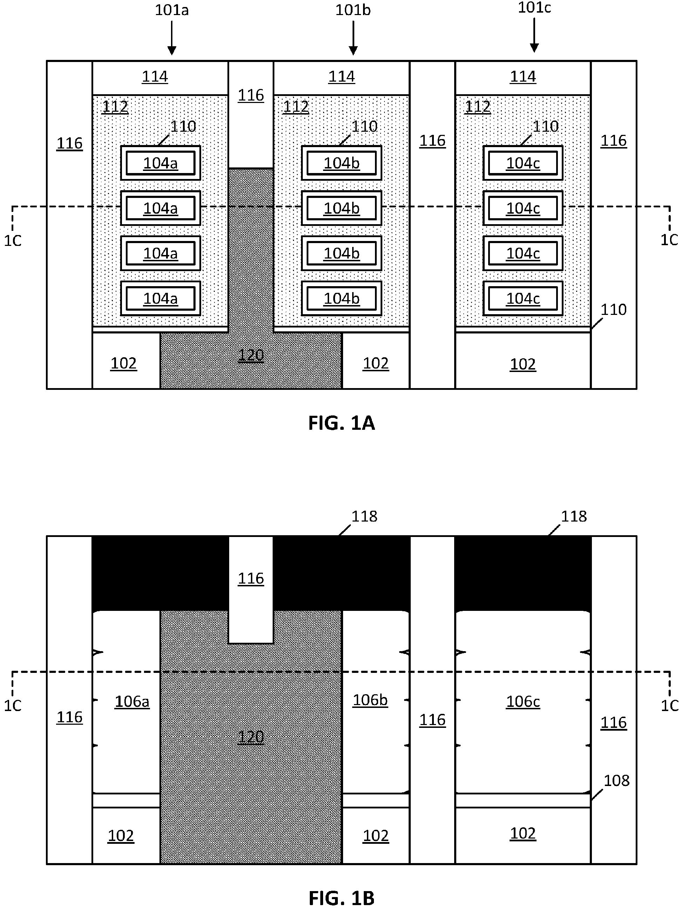

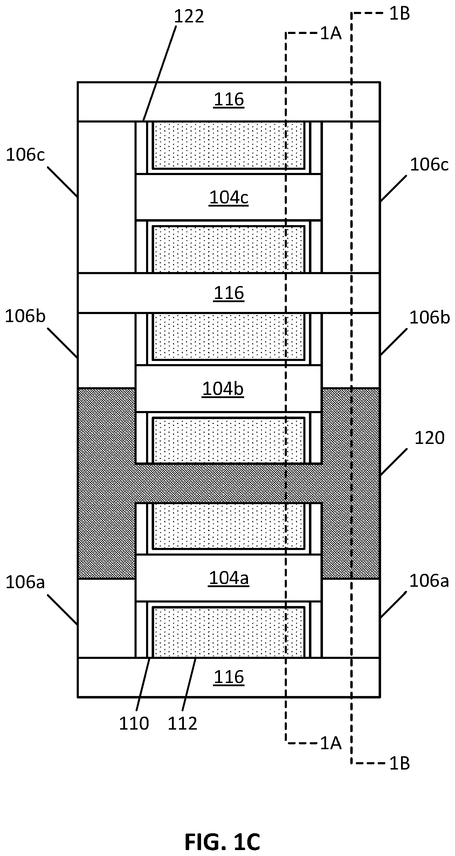

Figure 1A is a cross-sectional view taken across the gate trench of three example semiconductor devices, a first semiconductor device 101a, a second semiconductor device 101b, and a third semiconductor device 101c according to an embodiment of the present disclosure. Figure 1B is another cross-sectional view taken across the source/drain trench (or diffusion region and contact trench) adjacent to the gate trench either into or out of the page of Figure 1A. Figure 1C is a top-down cross-section view of the adjacent semiconductor devices 101a-101c taken across the dashed line 1C-1C depicted in both Figure 1A and Figure 1B. Figure 1A illustrates the cross-section taken across the dashed line 1A-1A depicted in Figure 1C, and Figure 1B illustrates the cross-section taken across the dashed line 1B-1B depicted in Figure 1C.

Each of semiconductor devices 101a - 101c may be, for example, non-planar metal oxide semiconductor (MOS) transistors, such as tri-gate (e.g., finFET) or gate-all-around (GAA) transistors, although other transistor topologies and types could also benefit from the techniques provided herein. The illustrated example embodiments use the GAA structure. The various illustrated semiconductor devices represent a portion of an integrated circuit that may contain any number of similar semiconductor devices.

As can be seen, semiconductor devices 101a-101c are formed over a dielectric base layer 102. According to some embodiments, a substrate is removed from the backside and replaced with one or more dielectric layers to form a backside interconnect structure that may include one or more interconnect layers, each layer having one or more conductive interconnect features within a layer of dielectric material (interlayer dielectric, or ILD). Accordingly, dielectric base layer 102 may represent a first dielectric layer or layers formed on the backside of the structure following the removal of the substrate. Dielectric base layer 102 may include any suitable dielectric material, such as any low-k dielectric material. In some examples, dielectric base layer 102 include silicon dioxide. Any number of semiconductor devices can be formed over dielectric base layer 102, but three are illustrated here as an example.

Each of semiconductor devices 101a, 101b, and 101c includes one or more corresponding nanoribbons 104a, 104b, and 104c, respectively, that extend parallel to one another along a direction between corresponding source or drain regions, as seen more clearly in Figure 1C (e.g., a first direction into and out of the page in the cross-section view of Figure 1A). Accordingly, nanoribbons 104a extend between source or drain regions 106a, nanoribbons 104b extend between source or drain regions 106b, and nanoribbons 104c extend between source or drain regions 106c. Nanoribbons 104a-104c are one example of semiconductor regions or semiconductor bodies that extend between source or drain regions. The term nanoribbon may also encompass other similar shapes such as nanowires or nanosheets. The semiconductor material of nanoribbons 104a-104c may be formed from the substrate. In some embodiments, semiconductor devices 101a - 101c may each include semiconductor regions in the shape of fins that can be, for example, native to the substrate (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitate forming of the illustrated nanoribbons 104a-104c during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches. As noted above, the substrate may be later removed and replaced with any number of dielectric layers.

According to some embodiments, nanoribbons 104a-104c (or other semiconductor bodies) extend between source or drain regions 106a-106c in the first direction to provide an active region (sometimes called channel region) for a transistor (e.g., the semiconductor region beneath the gate). It should be understood that the source or drain regions 106a-106c illustrated in the cross-section of Figure 1B are only along one side of nanoribbons 104a-104c (e.g., out of the page of FIG. 1A) and that similar source or drain regions may be present along the opposite side of nanoribbons 104a-104c, as shown in Figure 1C.

According to some embodiments, the source or drain regions are epitaxial regions that are provided using an etch-and-replace process. In other embodiments the source or drain regions could be, for example, implantation-doped native portions of the semiconductor fins or substrate. Any semiconductor materials suitable for source and drain regions can be used (e.g., group IV and group III-V semiconductor materials). The composition and doping of the source or drain regions may be the same or different, depending on the polarity of the transistors. In an example, for instance, one transistor is a p-type MOS (PMOS) transistor, and the other transistor is an n-type MOS (NMOS) transistor. As such, a given source or drain region may have a different dopant type (n or p) compared to another source or drain region within the same source/drain trench. Any number of source or drain configurations and materials can be used.

According to some embodiments, a lower dielectric layer 108 exists beneath source or drain regions 106a-106c. Lower dielectric layer 108 can include any suitable dielectric material, such as silicon dioxide or silicon nitride or silicon oxynitride and may be provide additional isolation between source or drain regions 106a-106c and any lower structures. Lower dielectric layer 108 may include the same dielectric material as dielectric base layer 102, such as silicon dioxide.

According to some embodiments, a gate structure extends over nanoribbons 104a - 104c of semiconductor devices 101a-101c along a second direction across the page of Figure 1A. The gate structure includes a gate dielectric 110 and a gate electrode 112. Gate dielectric 110 represents any number of dielectric layers present between nanoribbons 104a-104c and gate electrode 112. Gate dielectric 110 may also be present on the surfaces of other structures within the gate trench, such as along a bottom surface of the gate trench (e.g., on dielectric base layer 102). Gate dielectric 110 may include any suitable gate dielectric material(s). In some embodiments, gate dielectric 110 includes a layer of native oxide material (e.g., silicon dioxide) on the nanoribbons or other semiconductor regions making up the channel region of the devices, and a layer of high-k dielectric material (e.g., hafnium oxide) on the native oxide.

Gate electrode 112 may represent any number of conductive layers, such as any metal, metal alloy, or doped polysilicon layers. In some embodiments, gate electrode 112 includes one or more workfunction metals around nanoribbons 104a-104c. In some embodiments, one of semiconductor devices 101a-101c is a p-channel device that includes a workfunction metal having titanium around its nanoribbons and another semiconductor device is an n-channel device that includes a workfunction metal having tungsten around its nanoribbons. Gate electrode 112 may also include a fill metal or other conductive material around the workfunction metals to provide the whole gate electrode structure.

According to some embodiments, a dielectric cap layer 114 runs along a top surface of the gate structures in the gate trench. Accordingly, dielectric cap layer 114 may run along the second direction on the top surface of gate electrode 112 and be interrupted by any number of dielectric walls 116. Dielectric cap layer 114 may include the same dielectric material as dielectric walls 116, in some examples.

According to some embodiments, dielectric walls 116 may separate adjacent semiconductor devices such that a first gate structure is present over nanoribbons 104a, a second gate structure is present over nanoribbons 104b, and a third gate structure is present over nanoribbons 104c. Dielectric walls 116 extend along the first direction (e.g., into and out of the page) across the gate trench and further along the source/drain trench to isolate adjacent source or drain regions from each other. Accordingly, dielectric walls 116 extend between source or drain region 106a and source or drain region 106b and also between source or drain region 106b and source or drain region 106c. Dielectric walls 116 may continue to extend in the first direction to separate any number of other devices from one another within the integrated circuit. One or more of dielectric walls 116 extend through at least an entire thickness of the gate structures. In some examples, one of more dielectric walls 116 also extend through an entire thickness of dielectric base layer 102. Dielectric walls 116 may be formed from any sufficiently insulating material. Example materials for dielectric walls 116 include silicon nitride, silicon oxide, or silicon oxynitride. According to some embodiments, dielectric walls 116 each has a width between about 10 nm and about 15 nm.

According to some embodiments, any number of conductive contacts 118 may be formed on corresponding source or drain regions 106a - 106c. According to some embodiments, conductive contacts 118 include a conductive fill and a conductive liner along outside edges of the conductive fill. The conductive fill may be any suitably conductive material such as tungsten (W). Other conductive materials may include copper (Cu), ruthenium (Ru), cobalt (Co), titanium (Ti), molybdenum (Mo), or any alloys thereof. The conductive liner may be, for instance, a barrier layer and/or resistance-reducing layer that includes titanium or tantalum (e.g., titanium nitride or tantalum nitride) or some other suitable liner layer.

According to some embodiments, a backside conductive structure 120 extends through the device layer of semiconductor devices to contact an underside of one or more conductive contacts 118 and any backside interconnect features. Accordingly, backside conductive structure 120 may extend through an entire thickness of dielectric base layer 102 and along an entire thickness of adjacent source or drain regions 106a and 106b in the source/drain trench to contact conductive contacts 118. In some embodiments, a portion of dielectric wall 116 remains between conductive contacts 118 on backside conductive structure 120. As shown in Figure 1B, backside conductive structure 120 may extend partially around dielectric wall 116 in the source/drain trench.

According to some embodiments, backside conductive structure 120 may also extend partially through the gate trench and across the gate structure in the first direction as seen in Figure 1C. As seen in Figure 1A, backside conductive structure 120 may extend in a third direction (e.g., vertically) between adjacent gate structures around semiconductor devices 101a and 101b. Thus, backside conductive structure 120 may directly contact gate electrode 112 from the adjacent semiconductor devices 101a and 101b. In some embodiments, backside conductive structure 120 also directly contacts a portion of dielectric wall 116 between semiconductor devices 101a and 101b. The cross-sectional shape of backside conductive structure 120 may be different in the gate trench compared to the source/drain trench due to the different materials present in both trenches and the different etch processes through those materials used to form the backside cavity. The backside cavity is filled with conductive material to form backside conductive structure 120 as described below.

Each of conductive contacts 118 and backside conductive structure 120 may include any suitable conductive material, such as tungsten, molybdenum, or other metals. According to some embodiments, conductive contacts 118 and backside conductive structure 120 are formed together such that they include the same conductive material with no visible seams present between them. In such cases, the conductive contacts 118 and backside conductive structure 120 collectively form a continuous and monolithic body of conductive material. In some such cases, there may be one or more liner or barrier layers that are also common to the conductive contacts 118 and backside conductive structure 120, and the body of conductive material is on one or more of those layers. In some embodiments, the conductive material of backside conductive structure 120 is different from the conductive material of conductive contacts 118. In still other embodiments, the conductive material of conductive contacts 118 is the same as the conductive material of backside conductive structure 120, but is deposited at a different time so as to provide a seam or other indication of distinct depositions.

Figure 1C illustrates the plan view of the integrated circuit showing how nanoribbons 104a-104c extend between corresponding source or drain regions 110a - 110c. According to some embodiments, spacer structures 122 extend along the sides of the gate trench and isolate the gate trench from the source/drain trench (including epi regions and their respective contacts). Spacer structures 122 may include any suitable dielectric material, such as silicon nitride. The nanoribbons 104a - 104c (or other channel body) extend through spacer structures 122 to contact respective source or drain regions 106a - 106c. Backside conductive structure 120 may occupy portions of adjacent source/drain trenches and includes a segment that extends between them and through the gate structure, according to some embodiments.

### Fabrication Methodology

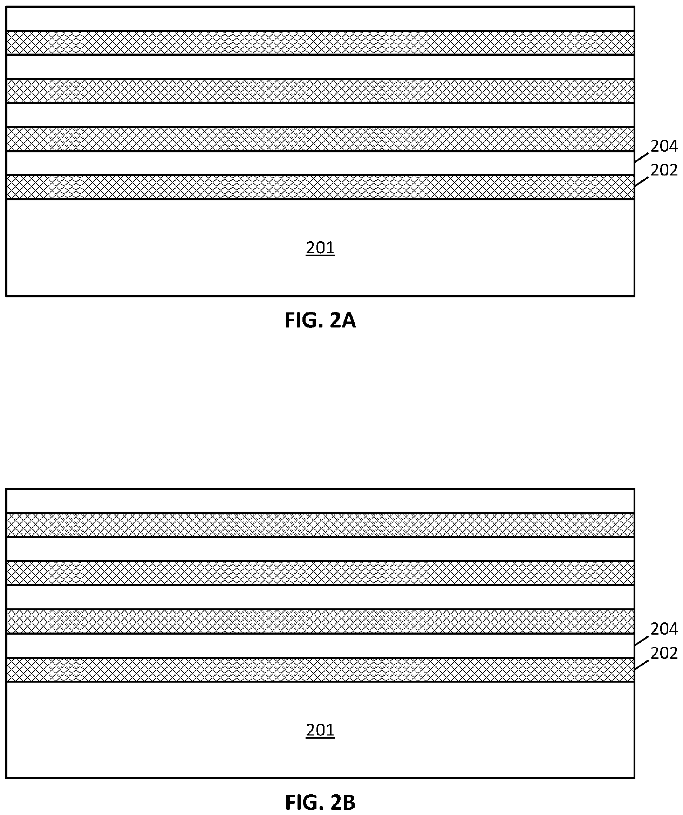

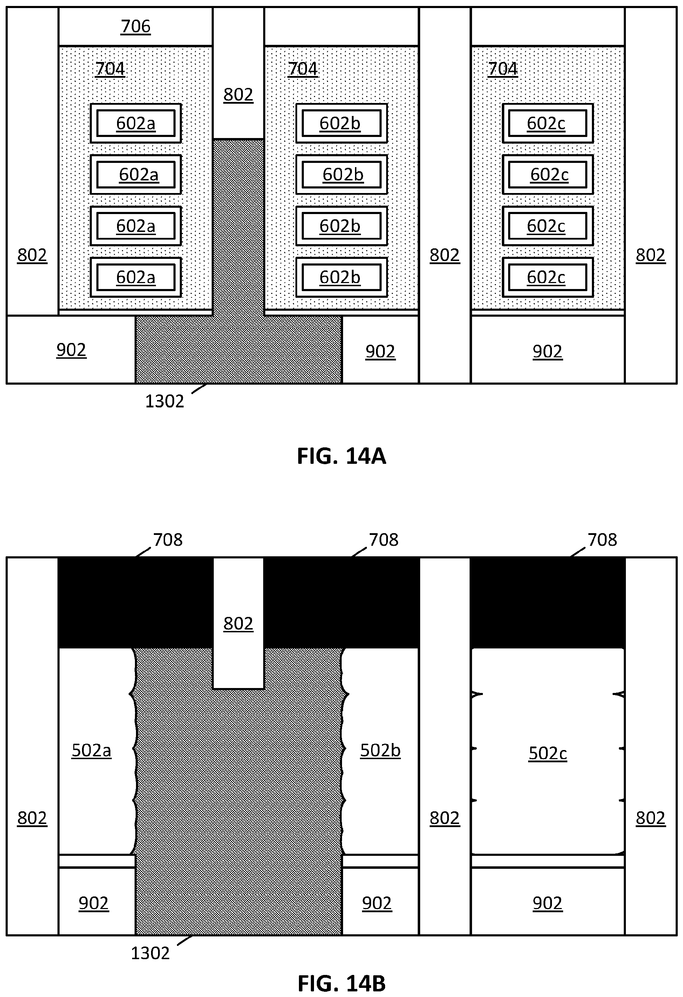

Figures 2A-14A and 2B-14B are cross-sectional views that collectively illustrate a first example process for forming an integrated circuit configured with a backside conductive structure that contacts one or more frontside contacts, in accordance with an embodiment of the present disclosure. Figures 2A-14A represent cross-sectional views taken across a gate trench of the integrated circuit, while Figures 2B-14B represent cross-sectional views taken across the source/drain trench adjacent to the gate trench along the same direction. Each figure shows an example structure that results from the process flow up to that point in time, so the depicted structure evolves as the process flow continues, culminating in the structure shown in Figures 14A and 14B, which is similar to the structure shown in Figures 1A and 1B, respectively. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. Figures sharing the same number (e.g., Figures 2A and 2B) illustrate different views of the structure at the same point in time during the process flow. Although the fabrication of a single backside conductive structure is illustrated in the aforementioned figures, it should be understood that any number of similar backside conductive structures can be fabricated across the integrated circuit using the same processes discussed herein.

Figures 2A and 2B illustrate parallel cross-sectional views taken through a stack of alternating semiconductor layers on a semiconductor substrate 201. Figure 2A is taken across a portion of the stack that will eventually become a gate trench while Figure 2B is taken across a portion of the stack that will eventually become a source/drain trench adjacent and parallel to the gate trench. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm), and the thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

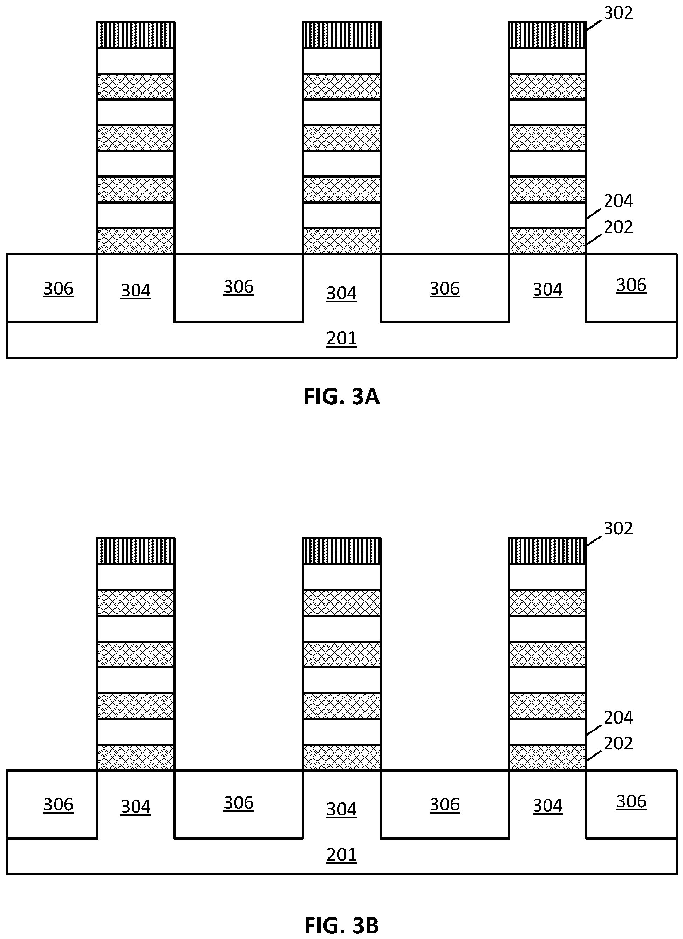

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. The rows of fins extend lengthwise in a first direction (e.g., into and out of the page of each cross-section view).

According to some embodiments, an anisotropic etching process through the layer stack continues into at least a portion of substrate 201, where the unetched portions of substrate 201 beneath the fins form subfin regions 304. The etched portions of substrate 201 may be filled with a dielectric fill 306 that acts as shallow trench isolation (STI) between adjacent fins. Dielectric fill 306 may be any suitable dielectric material such as silicon dioxide, and may be recessed to a desired depth as shown (in this example case, down to around the upper surface of subfin regions 304), so as to define the active portion of the fins that will be covered by a gate structure. In some embodiments, dielectric fill 306 is recessed below the top surface of subfin regions 304.

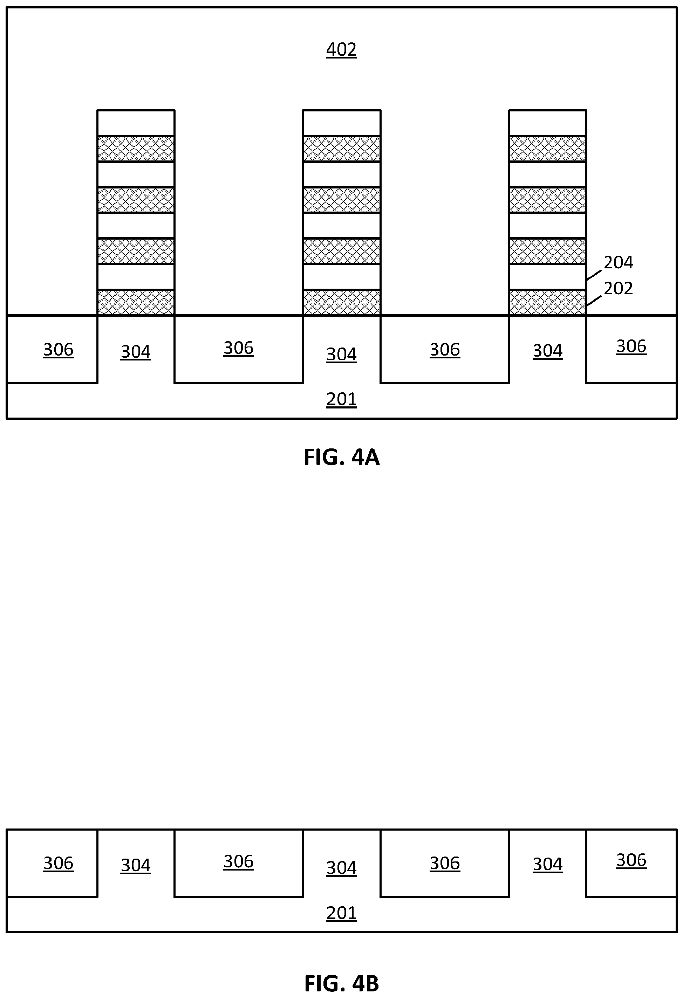

Figures 4A and 4B depict the cross-section views of the structure shown in Figures 3A and 3B, respectively, following the formation of a sacrificial gate 402 extending across the fins in a second direction different from the first direction, according to some embodiments. Sacrificial gate 402 may extend across the fins in a second direction that is orthogonal to the first direction. According to some embodiments, the sacrificial gate material is formed in parallel strips across the integrated circuit and removed in all areas not protected by a gate masking layer. Sacrificial gate 402 may be any suitable material that can be selectively removed without damaging the semiconductor material of the fins. In some examples, sacrificial gate 402 includes polysilicon.

As seen in the cross-section views, sacrificial gate 402 extends across the fins along the gate trench cross-section of Figure 4A but is not present along the source/drain trench cross-section of Figure 4B. Accordingly, sacrificial gate 402 (along with any gate spacers formed on the sidewalls of sacrificial gate 402) protect the underlying portions of the fins while the exposed portions of the fins are etched away as seen in Figure 4B. According to some embodiments, both semiconductor layers 204 and sacrificial layers 202 are etched at substantially the same rate using an anisotropic reactive ion etching (RIE) process. As observed in Figure 4B, the fins are completely removed above subfin regions 304. In some embodiments, the RIE process may also etch into subfin regions 304 thus recessing subfin regions 304 beneath a top surface of dielectric fill 306. In some embodiments, inner gate spacers can be formed after the source/drain trenches are etched and before any formation of source or drain regions. For instance, a selective etch can be used to laterally recess sacrificial layers 202, and that recess can then be filled with inner gate spacer material (e.g., silicon nitride or silicon oxynitride). Any excess gate spacer material can be removed with directional etching.

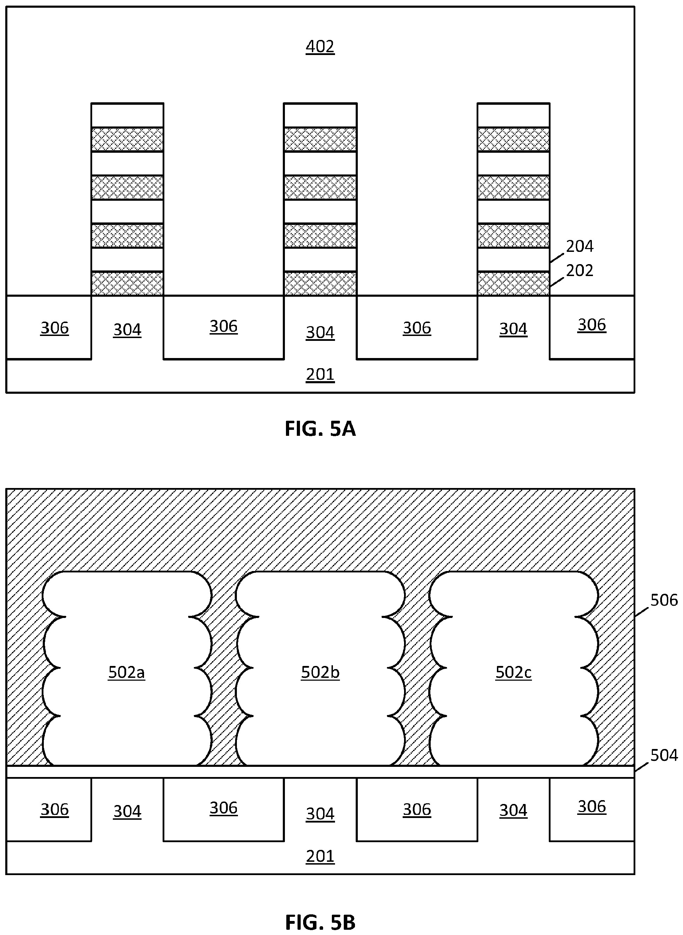

Figures 5A and 5B depict the cross-section views of the structure shown in Figures 4A and 4B, respectively, following the formation of source or drain regions 502a/502b/502c at the ends of each of the fins (extending into and out of the page in Figure 5A), according to some embodiments. Source or drain regions 502a/502b/502c may be epitaxially grown from the exposed ends of semiconductor layers 204, such that the material grows together or otherwise merges towards the middle of the trenches between fins, according to some embodiments. Note that epitaxial growth on one semiconductor layer 204 can fully or partially merge with epitaxial growth on one or more other semiconductor layers 204 in the same vertical stack. The degree of any such merging can vary from one embodiment to the next. In the example of a PMOS device, a given source or drain region may be a semiconductor material (e.g., group IV or group III-V semiconductor materials) having a higher dopant concentration of p-type dopants compared to n-type dopants. In the example of an NMOS device, a given source or drain region may be a semiconductor material (e.g., group IV or group III-V semiconductor materials) having a higher dopant concentration of n-type dopants compared to p-type dopants. According to some embodiments, source or drain regions 502a/502b/502c grown from different semiconductor devices may be aligned along the source/drain trench in the second direction as shown in Figure 5B.

According to some embodiments, a bottom dielectric layer 504 may be deposited prior to the formation of source or drain regions 502a/502b/502c. Bottom dielectric layer 504 may be any suitable dielectric material, such as silicon dioxide, silicon nitride, or silicon oxynitride. Bottom dielectric layer 504 may be included to provide isolation between source or drain regions 502a/502b/502c and subfin regions 304.

According to some embodiments, another dielectric fill 506 is provided along the source/drain trench. Dielectric fill 506 may extend between adjacent ones of the source or drain regions 502a/502b/502c along the second direction and also may extend up and over each of the source or drain regions 502a/502b/502c, according to some embodiments. Accordingly, each source or drain region may be isolated from any adjacent source or drain regions by dielectric fill 506. Dielectric fill 506 may be any suitable dielectric material, although in some embodiments, dielectric fill 506 includes the same dielectric material as dielectric fill 306 or bottom dielectric layer 504. In one example, each of dielectric fill 506, bottom dielectric layer 504, and dielectric fill 306 includes silicon dioxide. Dielectric fill 506 may not be present between certain adjacent source or drain regions in situations where the adjacent source or drain regions are desired to be electrically coupled together. According to some embodiments, a top surface of dielectric fill 506 may be polished using, for example, chemical mechanical polishing (CMP). The top surface of dielectric fill 506 may be polished until it is substantially coplanar with a top surface of sacrificial gate 402.

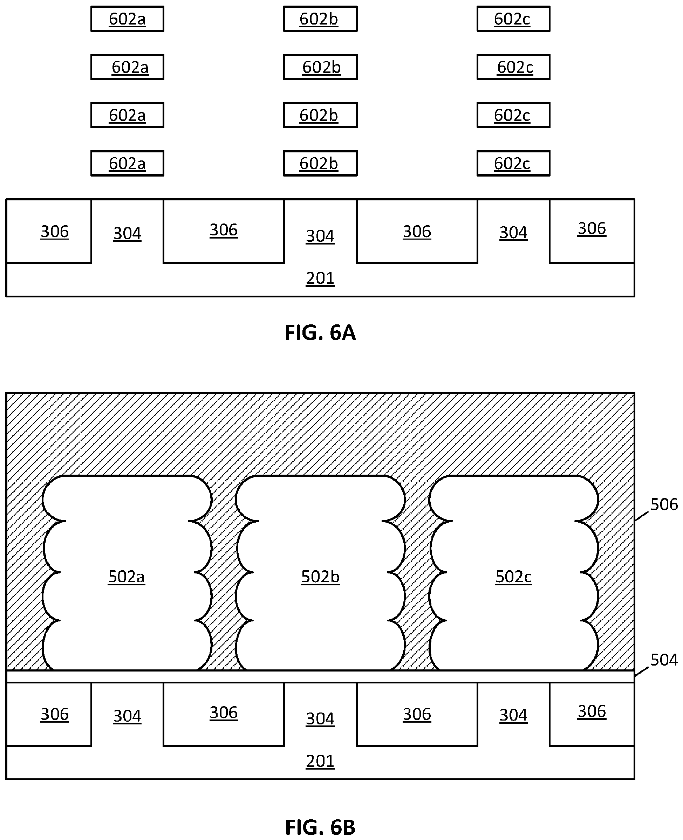

Figures 6A and 6B depict the cross-section views of the structure shown in Figures 5A and 5B, respectively, following the formation of nanoribbons 602a/602b/602c from semiconductor layers 204, according to some embodiments. Depending on the dimensions of the structures, nanoribbons 602a/602b/602c may also be considered nanowires or nanosheets. Sacrificial gate 402 may be removed using any wet or dry isotropic process thus exposing the alternating layer stack of the fins within the trenches left behind after the removal of sacrificial gate 402. Once sacrificial gate 402 is removed, sacrificial layers 202 may also be removed using a selective isotropic etching process that removes the material of sacrificial layers 202 but does not remove (or removes very little of) semiconductor layers 204 or any other exposed layers (e.g., inner gate spacers). At this point, the suspended (sometimes called released) semiconductor layers 204 form nanoribbons 602a/602b/602c that extend in the first direction (into and out of the page) between corresponding source or drain regions 502a/502b/502c.

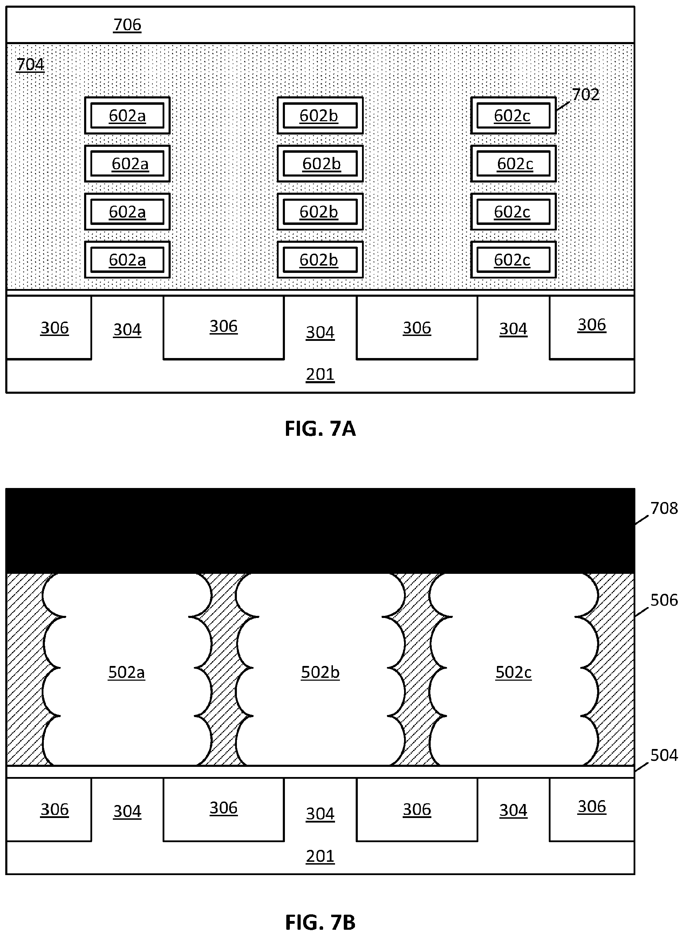

Figures 7A and 7B depict the cross-section views of the structure shown in Figures 6A and 6B, respectively, following the formation of a gate structure around nanoribbons 602a/602b/602c within the gate trench, according to some embodiments. As noted above, the gate structure includes a gate dielectric 702 and a gate electrode 704. Gate dielectric 702 may be conformally deposited around nanoribbons 602a/602b/602c using any suitable deposition process, such as atomic layer deposition (ALD). Gate dielectric 702 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 702 is hafnium oxide with a thickness between about 1 nm and about 5 nm. In some embodiments, gate dielectric 702 may include one or more silicates (e.g., titanium silicate, tungsten silicate, niobium silicate, and silicates of other transition metals). Gate dielectric 702 may be a multilayer structure, in some examples. For instance, gate dielectric 702 may include a first layer on nanoribbons 602a/602b/602c, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on gate dielectric 702 to improve its quality when a high-k dielectric material is used. In some embodiments, the high-k material can be nitridized to improve its aging resistance.

Gate electrode 704 may be deposited over gate dielectric 702 and can be any conductive structure. In some embodiments, gate electrode 704 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 704 may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, a gate cap 706 may be formed by first recessing gate electrode 704 and filling the recess with a dielectric material. The dielectric material may then be polished such that its top surface is substantially coplanar with any adjacent spacer structures or material within the source/drain trench. Gate cap 706 may be any suitable dielectric material, such as silicon nitride.

According to some embodiments, a portion of dielectric fill 506 may be recessed within the source/drain trench to expose at least a top surface of source or drain regions 502a/502b/502c. A conductive contact 708 may be formed within the recess to contact at least the top surfaces of source or drain regions 502a/502b/502c. In some embodiments, dielectric fill 506 is recessed far enough to expose one or more side surfaces of source or drain regions 502a/502b/502c, in which case conductive contact 708 also contacts the exposed side surfaces of source or drain regions 502a/502b/502c. Conductive contact 708 may include any suitable conductive material, such as tungsten, molybdenum, or ruthenium, for making electrical contact with the underlying source or drain regions 502a/502b/502c. A top surface of conductive contact 708 may be polished to be substantially coplanar with a top surface of gate cap 706.

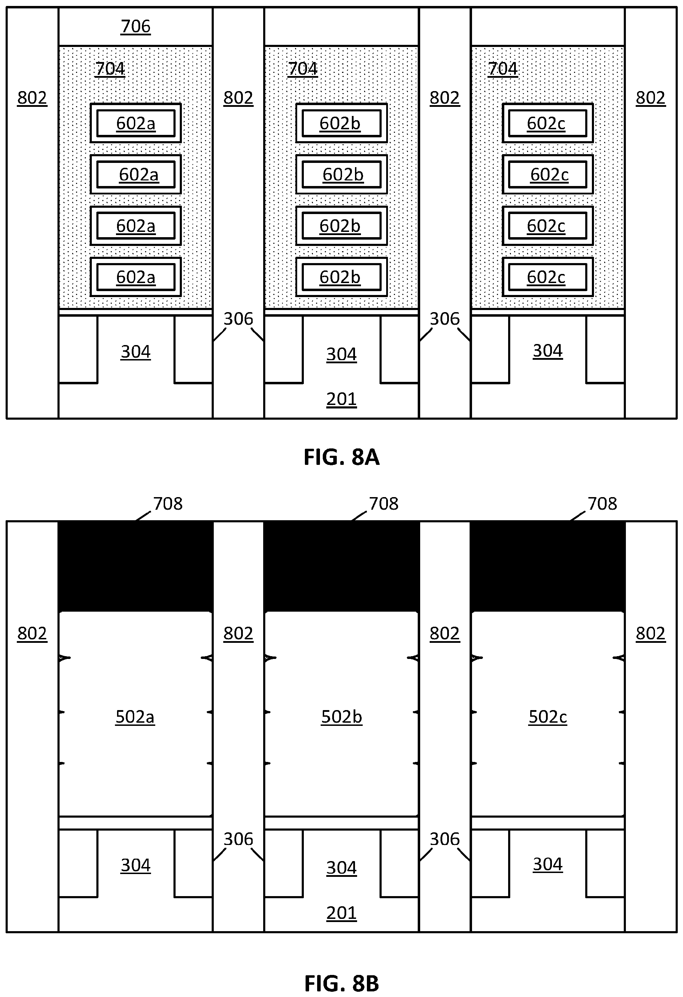

Figures 8A and 8B depict cross-section views of the structure shown in Figures 7A and 7B, respectively, following the formation of dielectric walls 802 extending in the first direction between adjacent devices, according to some embodiments. Dielectric walls 802 extend to a depth at least through an entire thickness of the gate structures to isolate separate gate structures along the second direction. In some embodiments, dielectric walls 802 extend into at least a portion of dielectric fill 306 or through an entire thickness of dielectric fill 306. In some embodiments, dielectric walls 802 extend entirely through dielectric fill 306 and into a portion of substrate 201.

According to some embodiments, dielectric walls 802 may be formed by first forming corresponding gate cut recesses through gate cap 706, contact 708 and gate electrode 704 using any suitable metal gate etch process that iteratively etches through portions of gate electrode 704 while simultaneously protecting the sidewalls of the recess from lateral etching to provide a high height-to-width aspect ratio recess (e.g., aspect ratio of 5:1 or higher, or 10: 1 or higher). The gate cut recesses may extend in the first direction through multiple gate trenches and source/drain trenches to isolate adjacent gate structures and source or drain regions. The gate cut recesses may be filled with one or more dielectric materials to form dielectric walls 802. For example, dielectric walls 802 may include only silicon oxide or silicon nitride or silicon carbide. In some examples, dielectric walls 802 include a first dielectric layer deposited first and a second dielectric layer or dielectric fill formed on the first dielectric layer. The first dielectric layer may include a high-k dielectric material (e.g., materials with a dielectric constant higher than that of silicon oxide or higher than 3.9) while the second dielectric layer may include a low-k dielectric material (e.g. materials with a dielectric constant equal to or lower than that of silicon oxide, such as porous silicon oxide, or equal to or lower than 3.9). In the illustrated example, dielectric wall 802 separates conductive contact 708 into different conductive contacts 708 over each of source or drain regions 502a/502b/502c. In some examples where devices are closely packed, dielectric walls 802 may contact one or more sidewalls of source or drain regions 502a/502b/502c.

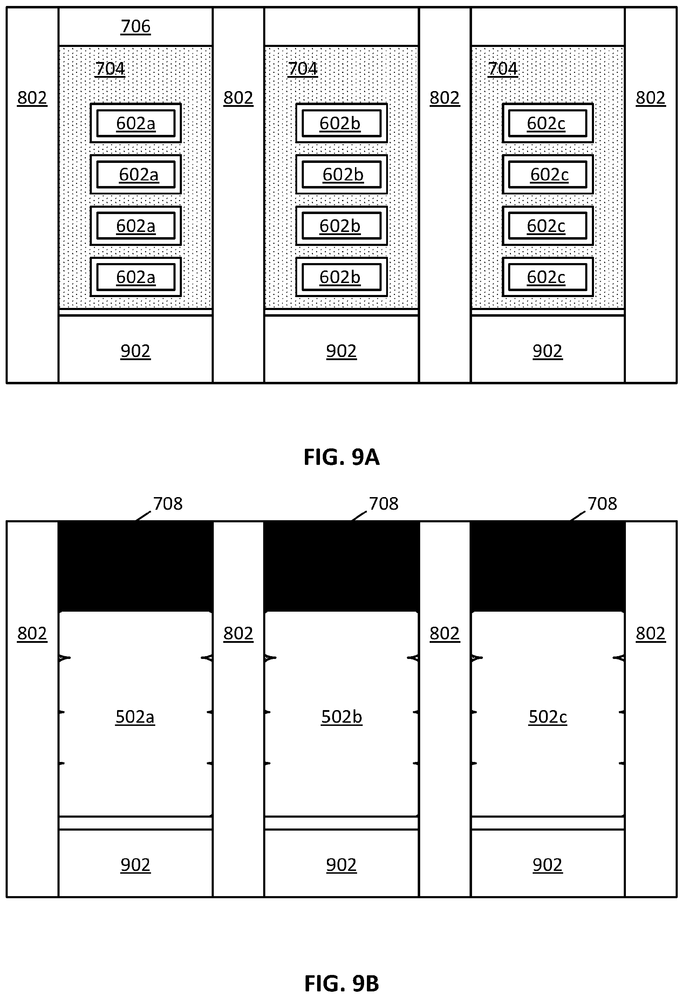

Figures 9A and 9B depict the cross-section views of the structure shown in Figures 8A and 8B, respectively, following the backside removal of substrate 201 and formation of a base dielectric layer 902, according to some embodiments. Substrate 201 may be removed via any combination of grinding, polishing, and/or etching processes. Once the bottom surfaces of dielectric fill 306 and subfin regions 304 are exposed, one or more additional etching processes may be performed to remove at least subfin regions 304. Various methods can then be used to form base dielectric layer 902. In one example, the recesses left behind from the removal of subfin regions 304 are filled with a dielectric material and polished using, for example, CMP, such that the additional dielectric material combined with dielectric fill 306 forms base dielectric layer 902. In another example, dielectric fill 306 is also removed and a fresh dielectric material is formed along the bottom of the structure and polished to form base dielectric layer 902. In either case, base dielectric layer 902 can include any suitable dielectric material, such as silicon dioxide. It should be noted that the process illustrated in Figures 9A and 9B for removing the substrate from the backside would be performed following the formation of any back-end-of-the-line (BEOL) structures, such as one or more interconnect layers, on the frontside of the structure. Each interconnect layer of such a frontside interconnect structure may include any number of conductive interconnect features in dielectric material. Each interconnect layer for the frontside interconnect structure (and backside interconnect structure) may be set off from other layers by a thin etch stop layer.

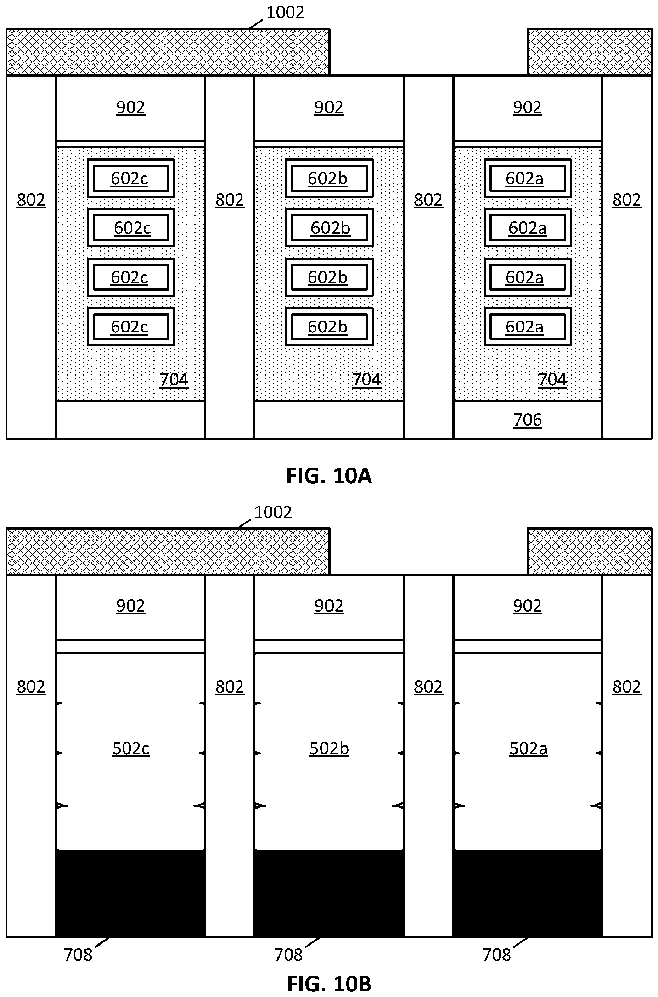

Figures 10A and 10B depict the cross-section views of the structure shown in Figures 9A and 9B, respectively, following the formation of a masking structure 1002 over a bottom surface of the integrated circuit, according to some embodiments. Note that the structure has been rotated 180 degrees in these figures such that base dielectric layer 902 is along the top in the illustrations yet is still referred to as the bottom or backside of the structure. Masking structure 1002 may include any number of hard mask layers or photoresist. Masking structure 1002 may be patterned using any suitable lithography techniques to expose at least one dielectric wall 802 and portions of base dielectric layer 902 on either side of the at least one dielectric wall 802 across both the gate trench and source/drain trench. According to some embodiments, the exposed areas define locations where the backside conductive structures will be formed.

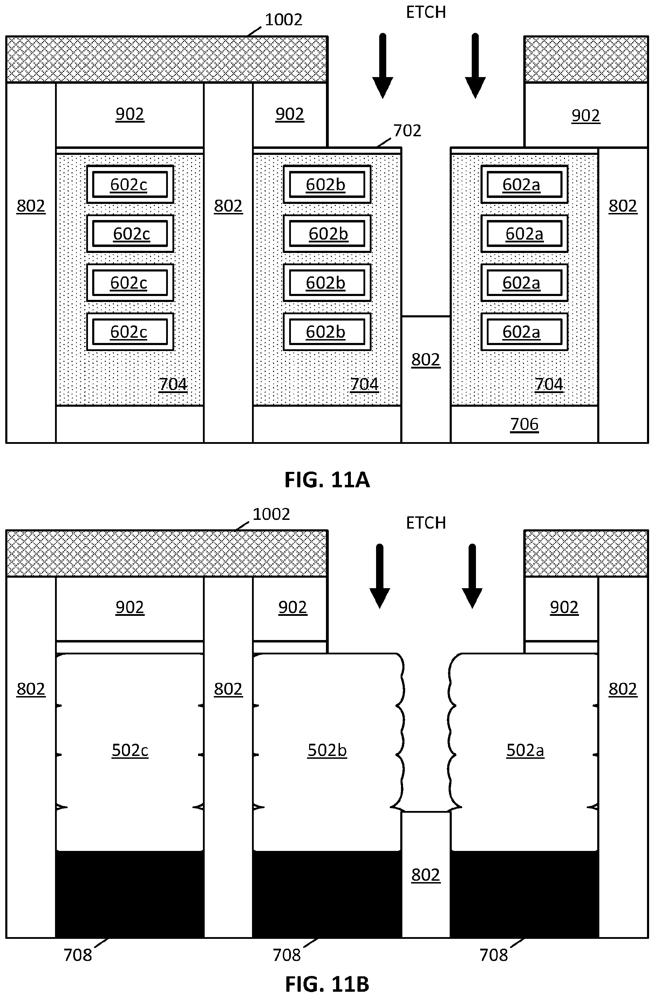

Figures 11A and 11B depict the cross-section views of the structure shown in Figures 10A and 10B, respectively, following one or more etching processes to remove portions of dielectric wall 802 and base dielectric layer 902 from the backside of the structure, according to some embodiments. An anisotropic RIE process may be used to remove exposed silicon dioxide and/or silicon nitride materials. As a consequence, backside portions of source or drain regions 502a and 502b are exposed.

According to some embodiments, the etching process recesses dielectric wall 802 between both source or drain regions 502a and 502b and between gate electrode 704. The depth of the recess is not critical so long as portions of source or drain regions 502a and 502b are exposed, according to some embodiments. In some examples, the material of gate dielectric 702 acts as an etch stop for the RIE process and remains following the etching procedure. For example, gate dielectric 702 may include hafnium oxide, which etches at a slower rate compared to silicon dioxide or silicon nitride.

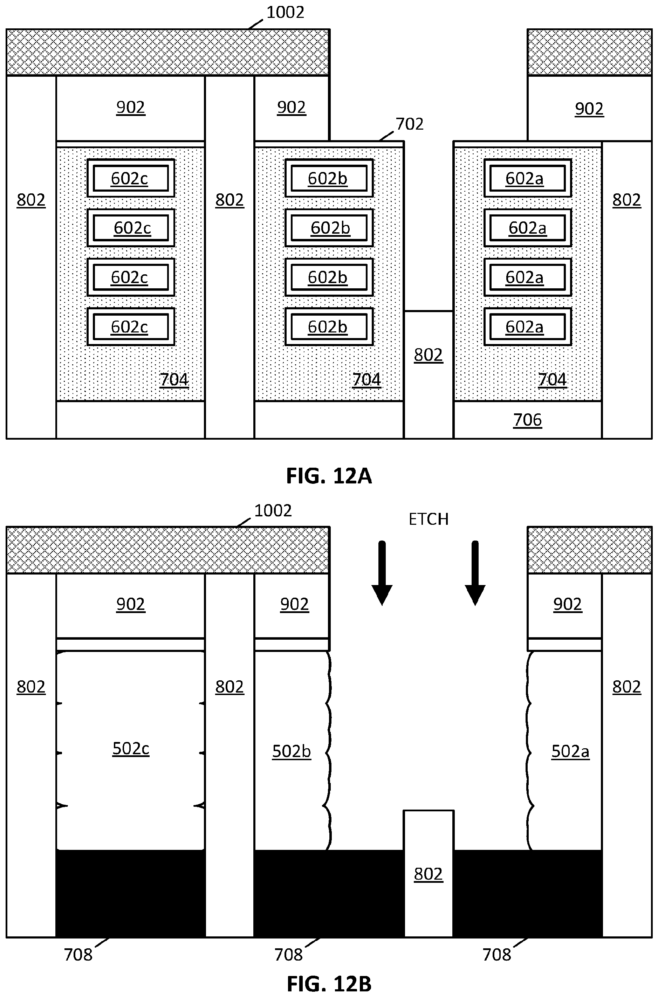

Figures 12A and 12B depict the cross-section views of the structure shown in Figures 11A and 11B, respectively, following one or more additional etching processes to remove the exposed portions of source or drain regions 502a and 502b, according to some embodiments. An RIE process may be used to etch any exposed semiconductor materials (e.g., SiGe or Si), such as the semiconductor material of source or drain regions 502a and 502b. According to some embodiments, portions of source or drain regions 502a and 502b are removed at least until an underside of one or more conductive contacts 708 are exposed. In some examples, all of source or drain regions 502a and 502b may be removed from the backside etch. Since these one or more etches may be tuned to selectively etch semiconductor materials, no further etching of any elements within the gate trench occurs, according to some embodiments. The etching processes described across Figures 11A, 11B, 12A, and 12B collectively form a backside cavity that exposes the underside of one or more frontside contacts 708.

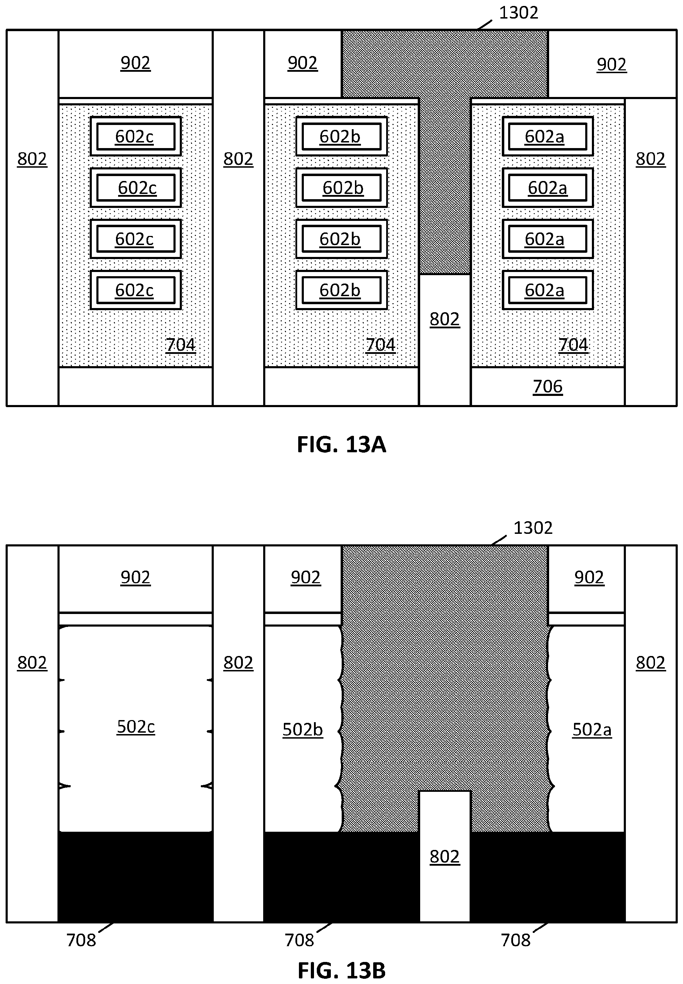

Figures 13A and 13B depict the cross-section views of the structure shown in Figures 12A and 12B, respectively, following the formation of a backside conductive structure 1302 within the backside cavity and the subsequent removal of masking structure 1002, according to some embodiments. Backside conductive structure 1302 extends through the device layer of the semiconductor devices to contact an underside of one or more conductive contacts 708. Backside conductive structure 1302 may form a conductive conduit between one or more conductive contacts 708 and any backside interconnect features. Accordingly, backside conductive structure 1302 may extend through an entire thickness of base dielectric layer 902 and along an entire thickness of any remaining portions of adjacent source or drain regions 502a and 502b in the source/drain trench to contact one or more conductive contacts 708. Furthermore, a portion of backside conductive structure 1302 may extend in the first direction between the adjacent gate electrodes around nanoribbons 602a and nanoribbons 602b. Backside conductive structure 1302 may contact a portion of the recessed dielectric wall 802. The remaining portion of the recessed dielectric wall 802 may still extend in the first direction between contacts 708 and between portions of the adjacent gate electrodes around nanoribbons 602a and nanoribbons 602b.

Backside conductive structure 1302 may include any suitable conductive material, such as tungsten, molybdenum, or other metals. According to some embodiments, conductive contacts 708 and backside conductive structure 1302 are formed together such that they include the same conductive material with no visible seams present between them. In some embodiments, the conductive material of backside conductive structure 1302 is different from the conductive material of conductive contacts 708.

Figures 14A and 14B depict the cross-section views of the structure shown in Figures 13A and 13B, respectively, following a reorientation of the structure such that frontside contacts 708 are once again illustrated at the top of the device. As can be seen from this fabrication process, backside conductive structure 1302 may cause a short between both adjacent gate electrodes around nanoribbons 602a and nanoribbons 602b and their corresponding source or drain regions 502a and 502b. Accordingly, such devices may be "dummy" devices or devices that are not used as active transistors in the circuit.

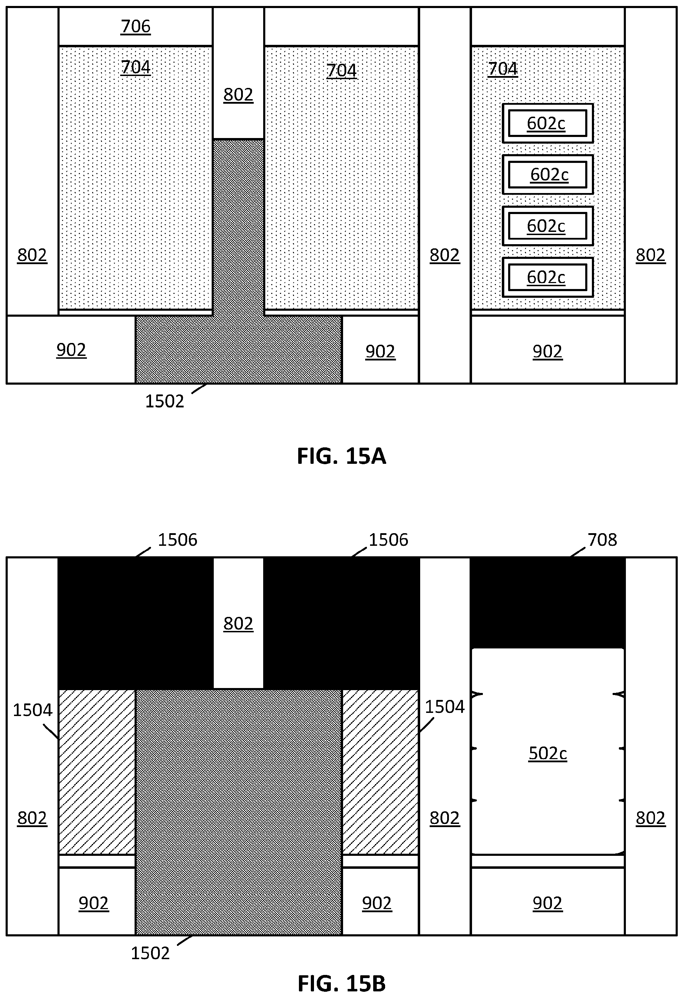

According to some embodiments, some portions of the semiconductor regions (e.g., the semiconductor fins) may be removed in regions of the integrated circuit prior to the formation of the gate structures and source or drain regions. As a result, these regions of the circuit do not have any semiconductor structures in the way of forming backside conductive contacts. Figures 15A and 15B are cross-sectional views of a portion of an integrated circuit illustrate a backside conductive structure extending through a region of the integrated circuit where no semiconductor devices are present. The gate structure, including gate electrode 704, still extends through the region, but no nanoribbons or source or drain regions are present in the region. Accordingly, a backside conductive structure 1502 may extend through a dielectric fill 1504 within the source/drain trench to contact frontside contacts 1506. Backside conductive structure 1502 may also extend upward in the gate trench in a similar manner as discussed above. Dielectric fill 1504 may be any suitable dielectric material, such as silicon dioxide.

According to some embodiments, frontside contacts 1506 may have a greater thickness compared to other frontside contacts 708 on source or drain regions due to the etching process used to create the recess in which the contacts are formed. The etching process may selectively remove dielectric material and stop of the top surface of source or drain region 502c while continuing to etch deeper into dielectric fill 1504.

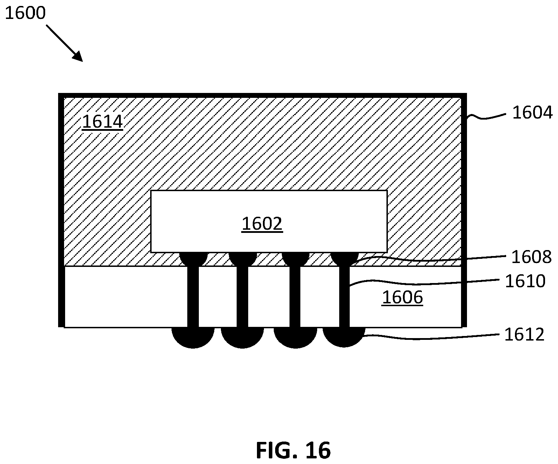

Figure 16 illustrates an example embodiment of a chip package 1600, in accordance with an embodiment of the present disclosure. As can be seen, chip package 1600 includes one or more dies 1602. One or more dies 1602 may include at least one integrated circuit having semiconductor devices, such as any of the semiconductor devices disclosed herein. One or more dies 1602 may include any other circuitry used to interface with other devices formed on the dies, or other devices connected to chip package 1600, in some example configurations.

As can be further seen, chip package 1600 includes a housing 1604 that is bonded to a package substrate 1606. The housing 1604 may be any housing, and may provide, for example, electromagnetic shielding and environmental protection for the components of chip package 1600. The one or more dies 1602 may be conductively coupled to a package substrate 1606 using connections 1608, which may be implemented with any number of connection mechanisms, such as solder bumps, ball grid array (BGA), pins, or wire bonds, to name a few examples. Package substrate 1606 may be any package substrate, but in some cases includes a dielectric material having conductive pathways (e.g., including conductive vias and lines) extending through the dielectric material between the faces of package substrate 1606, or between different locations on each face. In some embodiments, package substrate 1606 may have a thickness less than 1 millimeter (e.g., between 0.1 millimeters and 0.5 millimeters), although any number of package geometries can be used. Additional conductive contacts 1612 may be disposed at an opposite face of package substrate 1606 for conductively contacting, for instance, a printed circuit board (PCB). One or more vias 1610 extend through a thickness of package substrate 1606 to provide conductive pathways between one or more of connections 1608 to one or more of contacts 1612. Vias 1610 are illustrated as single straight columns through package substrate 1606 for ease of illustration, although other configurations can be used (e.g., damascene, dual damascene, through-silicon via, or an interconnect feature that meanders through the thickness of substrate 1606 to contact one or more intermediate locations therein). In still other embodiments, vias 1610 are fabricated by multiple smaller stacked vias, or are staggered at different locations across package substrate 1606. In the illustrated embodiment, contacts 1612 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1612, to inhibit shorting.

In some embodiments, a mold material 1614 may be disposed around the one or more dies 1602 included within housing 1604 (e.g., between dies 1602 and package substrate 1606 as an underfill material, as well as between dies 1602 and housing 1604 as an overfill material). Although the dimensions and qualities of the mold material 1614 can vary from one embodiment to the next, in some embodiments, a thickness of mold material 1614 is less than 1 millimeter. Example materials that may be used for mold material 1614 include epoxy mold materials, as suitable. In some cases, the mold material 1614 is thermally conductive, in addition to being electrically insulating.

### Methodology

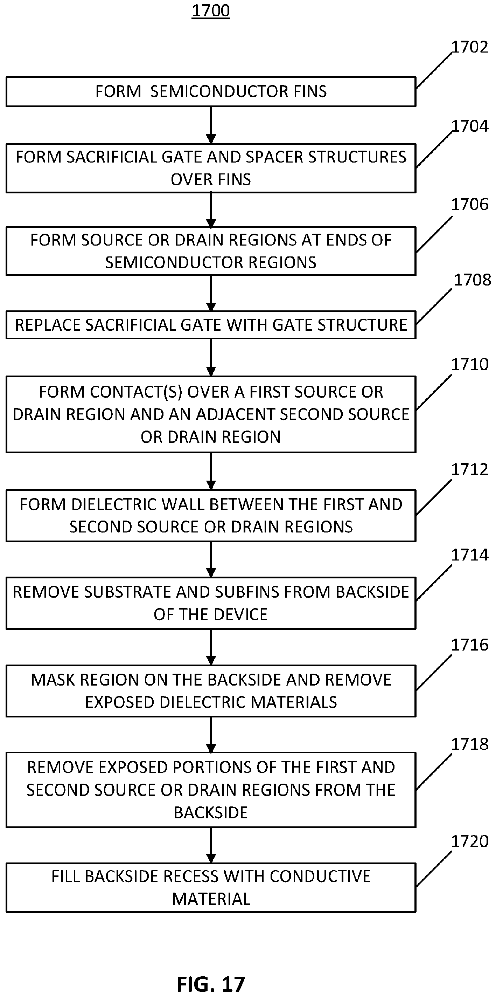

Figure 17 is a flow chart of a method 1700 for forming at least a portion of an integrated circuit, according to an embodiment. Various operations of method 1700 may be illustrated in Figures 2A-14A and Figures 2B-14B. However, the correlation of the various operations of method 1700 to the specific components illustrated in the aforementioned figures is not intended to imply any structural and/or use limitations. Rather, the aforementioned figures provide example embodiments of method 1700. Other operations may be performed before, during, or after any of the operations of method 1700. For example, method 1700 does not explicitly describe all processes that are performed to form common transistor structures. Some of the operations of method 1700 may be performed in a different order than the illustrated order.

Method 1700 begins with operation 1702 where any number of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

According to some embodiments, a dielectric layer is formed around subfin portions of the one or more fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 1700 continues with operation 1704 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a crosshatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride.

Method 1700 continues with operation 1706 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some example embodiments, the source or drain regions are NMOS source or drain regions (e.g., epitaxial silicon) or PMOS source or drain regions (e.g., epitaxial SiGe).

According to some embodiments, a dielectric fill is formed over the source or drain regions. The dielectric fill may be formed adjacent to the various source or drain regions for additional electrical isolation between adjacent regions. The dielectric fill may also extend over a top surface of the source or drain regions. The dielectric fill can take up any remaining space along the source/drain trench, according to some embodiments. The dielectric fill may include any suitable dielectric material, such as silicon dioxide or silicon oxynitride.

Method 1700 continues with operation 1708 where the sacrificial gate is replaced with a gate structure. According to some embodiments, the sacrificial gate may be removed along with any sacrificial layers within the exposed fins between the spacer structures (in the case of GAA structures). A gate structure may then be formed in place of the sacrificial gate. The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

Method 1700 continues with operation 1710 where one or more contacts are formed over a first source or drain region and a second adjacent source or drain region. In some embodiments, a conductive layer forms a single contact over both the first and second source or drain regions within the source/drain trench. The conductive layer may include any suitable conductive material, such as tungsten, molybdenum, ruthenium, or cobalt. The conductive layer represents any number of different conductive materials that may be deposited to form the contact and may extend over the top surfaces of any number of source or drain regions within the source/drain trench.

Method 1700 continues with operation 1712 where a dielectric wall is formed through the gate structure between adjacent pairs of fins and through the source/drain trench between the first source or drain region and the second source or drain region. According to some embodiments, the dielectric wall also cuts through the conductive layer to isolate separate conductive contacts on each of the first source or drain region and the second source or drain region. A trench may be etched through both the gate structure and through the dielectric fill around the source or drain regions. The trench may extend substantially parallel and lengthwise to the fins or nanowires. A single etching process may be used to form multiple trenches between adjacent devices using a mask with a grating pattern. A reactive ion etching (RIE) process may be used to cut through the various material layers and form the trenches. The trench may be filled with a dielectric material to form the dielectric wall between the first source or drain region and the second source or drain region. The trench may be filled with any suitable low-K dielectric material, such as silicon nitride. In some embodiments, each pair of semiconductor devices in the integrated circuit includes a dielectric wall between them.

Method 1700 continues with operation 1714 where the substrate and any subfins are removed from the backside of the device. The substrate may be removed via any combination of grinding, polishing, and/or etching processes. In some embodiments, the substrate may continue to be thinned from the backside until bottom surfaces of the dielectric layer and/or the subfin portions adjacent to eh dielectric layer are exposed. Once they are exposed, one or more additional etching processes may be performed to remove at least the subfin regions. In some examples, the dielectric layer is also removed. In any case, additional dielectric material is deposited on the backside to create a base dielectric layer beneath the semiconductor devices. The base dielectric layer can include any suitable dielectric material, such as silicon dioxide. It should be noted that the dielectric walls may still extend through at least a portion of a thickness of the base dielectric layer.

Method 1700 continues with operation 1716 where a masking structure is formed on the backside of the device and exposed dielectric materials are removed from the backside. According to some embodiments, any number of hard mask or photoresist layers may be used to form the masking structure. Lithographic techniques can be used to pattern the masking structure to expose portions of the base dielectric layer and/or dielectric walls from the backside. Then, any number of dielectric etching processes may be performed to remove the exposed dielectric materials not protected by the masking structure. For example, the removed dielectric materials may include portions of the base dielectric layer, portions of one or more of the dielectric walls, and/or any other dielectric fill materials in the gate and source/drain trenches. According to some embodiments, some exposed dielectric materials may not be etched or be etched little compared to other dielectric materials. For example, an exposed gate dielectric that includes hafnium oxide on the bottom of a gate electrode may etch slower compared to other dielectric layers that include silicon dioxide or silicon nitride. According to some embodiments, one or more of the dielectric walls may be recessed due to the one or more dielectric etching processes to expose sidewalls of the gate electrode within the gate trench.

Method 1700 continues with operation 1718 where one or more etching processes are performed to remove exposed portions of the first and second source or drain regions from the backside. An RIE process may be used to etch any exposed semiconductor materials of the source or drain regions (e.g., SiGe or Si). According to some embodiments, portions of the source or drain regions are removed at least until an underside of the one or more conductive contacts are exposed. In some examples, all of the first and second source or drain regions may be removed from the backside etch. Since these one or more etches may be tuned to selectively etch semiconductor materials, no further etching (or substantially little etching) of any exposed dielectric or metal elements within the gate trench occurs, according to some embodiments. A cavity is formed through the backside of the device that exposes at least a portion of one or more frontside conductive contacts using the etching processes of operations 1716 and 1718.

Method 1700 continues with operation 1720 where wherein a conductive material is formed within the backside cavity to form a conductive backside structure. The backside conductive structure may form a conductive conduit between the one or more frontside conductive contacts and any backside interconnect features. Accordingly, the backside conductive structure may extend through an entire thickness of the base dielectric layer and along an entire thickness of any remaining portions of the adjacent first and second source or drain regions in the source/drain trench. Furthermore, a portion of the backside conductive structure may extend in between the gate electrodes of the adjacent semiconductor devices (e.g., where a dielectric wall had previously been formed). The backside conductive structure may include any suitable conductive material, such as tungsten, molybdenum, or other metals.

### Example System

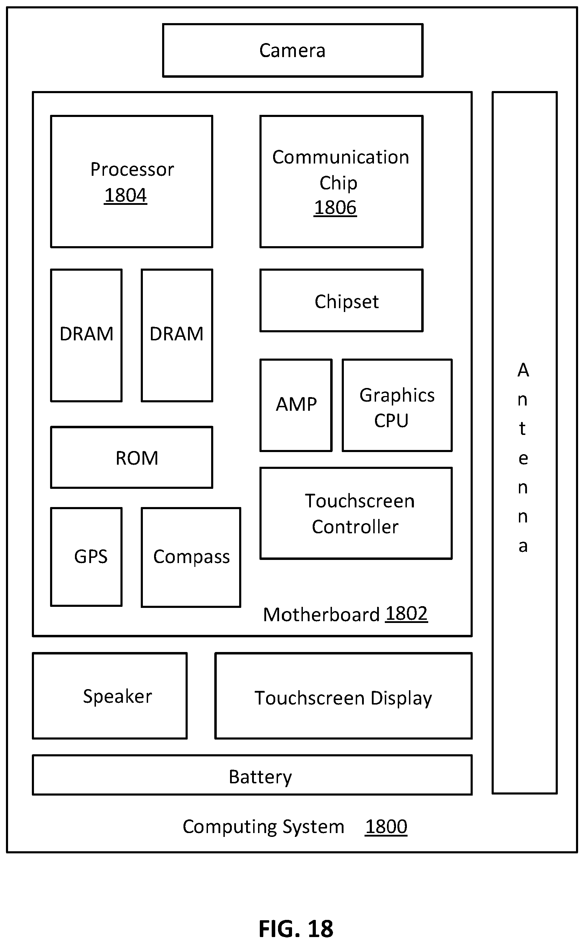

FIG. 18 is an example computing system implemented with one or more of the integrated circuit structures as disclosed herein, in accordance with some embodiments of the present disclosure. As can be seen, the computing system 1800 houses a motherboard 1802. The motherboard 1802 may include a number of components, including, but not limited to, a processor 1804 and at least one communication chip 1806, each of which can be physically and electrically coupled to the motherboard 1802, or otherwise integrated therein. As will be appreciated, the motherboard 1802 may be, for example, any printed circuit board (PCB), whether a main board, a daughterboard mounted on a main board, or the only board of system 1800, etc.

Depending on its applications, computing system 1800 may include one or more other components that may or may not be physically and electrically coupled to the motherboard 1802. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1800 may include one or more integrated circuit structures or devices configured in accordance with an example embodiment (e.g., a module including an integrated circuit on a substrate, the substrate having semiconductor devices that include a backside conductive structure that extends upwards to contact one or more frontside contacts). In some embodiments, multiple functions can be integrated into one or more chips (e.g., for instance, note that the communication chip 1806 can be part of or otherwise integrated into the processor 1804).

The communication chip 1806 enables wireless communications for the transfer of data to and from the computing system 1800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1806 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1800 may include a plurality of communication chips 1806. For instance, a first communication chip 1806 may be dedicated to shorter range wireless communications such as Wi-Fi and Bluetooth and a second communication chip 1806 may be dedicated to longer range wireless communications such as GPS, EDGE, GPRS, CDMA, WiMAX, LTE, Ev-DO, and others.

The processor 1804 of the computing system 1800 includes an integrated circuit die packaged within the processor 1804. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1806 also may include an integrated circuit die packaged within the communication chip 1806. In accordance with some such example embodiments, the integrated circuit die of the communication chip includes one or more semiconductor devices as variously described herein. As will be appreciated in light of this disclosure, note that multi-standard wireless capability may be integrated directly into the processor 1804 (e.g., where functionality of any chips 1806 is integrated into processor 1804, rather than having separate communication chips). Further note that processor 1804 may be a chip set having such wireless capability. In short, any number of processor 1804 and/or communication chips 1806 can be used. Likewise, any one chip or chip set can have multiple functions integrated therein.

In various implementations, the computing system 1800 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1800 may be combined or integrated in a system-on-a-chip (SoC) architecture. In some embodiments, the components may be hardware components, firmware components, software components or any suitable combination of hardware, firmware or software.

## Claims

1. An integrated circuit comprising:
a first semiconductor region extending in a first direction from a first source or drain region;
a second semiconductor region extending in the first direction from a second source or drain region, the second source or drain region spaced from the first source or drain region in a second direction different from the first direction;
a first gate structure around the first semiconductor region and a second gate structure around the second semiconductor region;
a dielectric layer (108, 504, 902) beneath the first gate structure and the second gate structure;
a dielectric wall (116, 802) between the first semiconductor region and the second semiconductor region and extending in the first direction such that the dielectric wall (116, 802) extends between the first gate structure and the second gate structure;
a first contact on a top surface of the first source or drain region and a second contact on a top surface of the second source or drain region; and
a conductive structure (120, 1302, 1502) extending through an entire thickness of the dielectric layer (108, 504, 902) and along an entire thickness of the first source or drain region and the second source or drain region to contact one or both of the first contact and the second contact, wherein a portion of the conductive structure (120, 1302, 1502) also extends in the first direction between the first gate structure and the second gate structure.

2. The integrated circuit of claim 1, wherein the dielectric layer (108, 504, 902) is a first dielectric layer, and the dielectric wall (116, 802) comprises a second dielectric layer along one or more edges of the dielectric wall (116, 802) and a dielectric fill (306, 506, 1504) in a remaining volume of the dielectric wall (116, 802).

3. The integrated circuit of claim 2, wherein the second dielectric layer comprises a low-K dielectric material.

4. The integrated circuit of any one of claims 1 through 3, wherein the first semiconductor region comprises a plurality of first semiconductor nanoribbons and the second semiconductor region comprises a plurality of second semiconductor nanoribbons.

5. The integrated circuit of claim 4, wherein the plurality of first semiconductor nanoribbons and the plurality of second semiconductor nanoribbons comprise germanium, silicon, or a combination thereof.

6. The integrated circuit of any one of claims 1 through 5, wherein the first gate structure and the second gate structure each include a gate dielectric around the first semiconductor region and the second semiconductor region and along a bottom surface of the first gate structure and second gate structure.

7. The integrated circuit of claim 6, wherein the gate dielectric comprises hafnium and oxygen.

8. The integrated circuit of claim 6 or 7, wherein the conductive structure (120, 1302, 1502) contacts the gate dielectric beneath the first gate structure and second gate structure.

9. The integrated circuit of any one of claims 1 through 8, wherein the conductive structure (120, 1302, 1502) comprises a same conductive material as both the first contact and the second contact.

10. The integrated circuit of any one of claims 1 through 9, wherein the conductive structure (120, 1302, 1502) comprises tungsten or copper.

11. The integrated circuit of any one of claims 1 through 10, wherein the conductive structure (120, 1302, 1502) contacts a surface of the dielectric wall (116, 802) between the first gate structure and second gate structure.

12. The integrated circuit of any one of claims 1 through 11, wherein a bottom surface of the conductive structure (120, 1302, 1502) is substantially coplanar with a bottom surface of the dielectric layer (108, 504, 902).

13. A printed circuit board comprising the integrated circuit of any one of claims 1 through 12.

14. A method of forming an integrated circuit, the method comprising:
forming a first fin comprising first semiconductor material and a second fin comprising second semiconductor material, the first and second fins extending above a substrate (201) and each extending in a first direction;
forming a gate electrode (112, 704) extending over the first semiconductor material and the second semiconductor material in a second direction different from the first direction;
forming a first source or drain region at a first end of the first fin;
forming a second source or drain region at a first end of the second fin;
forming a contact over the first source or drain region and the second source or drain region;
forming a recess through the gate electrode (112, 704) between the first fin and the second fin, the recess further extending in the first direction between the first source or drain region and the second source or drain region, wherein the recess splits the gate electrode (112, 704) into a first gate electrode and a second gate electrode and splits the contact into a first contact and a second contact;
forming a dielectric wall (116, 802) within the recess;
removing the substrate (201) and forming a dielectric layer (108, 504, 902) beneath the first gate electrode and the second gate electrode;
recessing a portion of the dielectric wall (116, 802) from a backside of the integrated circuit such that a top surface of the recessed dielectric wall (116, 802) is between the first gate electrode and the second gate electrode;
removing exposed portions of the first source or drain region and the second source or drain region from the backside of the integrated circuit such that portions of one or both of the first contact and the second contact are exposed from the backside; and
forming a conductive structure (120, 1302, 1502) within a recessed area from the backside such that the conductive structure (120, 1302, 1502) contacts one or both of the first contact and the second contact.

15. The method of claim 14, wherein recessing the portion of the dielectric wall (116, 802) further comprises recessing an entire thickness of a portion of the dielectric layer (108, 504, 902).

## Patentansprüche

1. Integrierte Schaltung, umfassend:
ein erstes Halbleitergebiet, das sich von einem ersten Source- oder Drain-Gebiet in einer ersten Richtung erstreckt;
ein zweites Halbleitergebiet, das sich von einem zweiten Source- oder Drain-Gebiet in der ersten Richtung erstreckt, wobei das zweite Source- oder Drain-Gebiet von dem ersten Source- oder Drain-Gebiet in einer zweiten Richtung beabstandet ist, die verschieden von der ersten Richtung ist;
eine erste Gate-Struktur um das erste Halbleitergebiet herum und eine zweite Gate-Struktur um das zweite Halbleitergebiet herum;
eine dielektrische Schicht (108, 504, 902) unter der ersten Gate-Struktur und der zweiten Gate-Struktur;
eine dielektrische Wand (116, 802) zwischen dem ersten Halbleitergebiet und dem zweiten Halbleitergebiet, die sich in der ersten Richtung erstreckt, sodass sich die dielektrische Wand (116, 802) zwischen der ersten Gate-Struktur und der zweiten Gate-Struktur erstreckt;
einen ersten Kontakt auf einer Oberseite des ersten Source- oder Drain-Gebiets und einen zweiten Kontakt auf einer Oberseite des zweiten Source- oder Drain-Gebiets; und
eine leitfähige Struktur (120, 1302, 1502), die sich durch eine vollständige Dicke der dielektrischen Schicht (108, 504, 902) und entlang einer vollständigen Dicke des ersten Source- oder Drain-Gebiets und des zweiten Source- oder Drain-Gebiets erstreckt, um mit einem oder beiden des ersten Kontakts und des zweiten Kontakts in einen Kontakt zu stehen, wobei sich ein Abschnitt der leitfähigen Struktur (120, 1302, 1502) auch in der ersten Richtung zwischen der ersten Gate-Struktur und der zweiten Gate-Struktur erstreckt.

2. Integrierte Schaltung nach Anspruch 1, wobei die dielektrische Schicht (108, 504, 902) eine erste dielektrische Schicht ist und wobei die dielektrische Wand (116, 802) eine zweite dielektrische Schicht entlang eines oder mehrerer Ränder der dielektrischen Wand (116, 802) und eine dielektrische Füllung (306, 506, 1504) in einem verbleibenden Volumen der dielektrischen Wand (116, 802) umfasst.

3. Integrierte Schaltung nach Anspruch 2, wobei die zweite dielektrische Schicht ein Material mit niedriger Dielektrizitätskonstante umfasst.

4. Integrierte Schaltung nach einem der Ansprüche 1 bis 3, wobei das erste Halbleitergebiet eine Mehrzahl von ersten Halbleiternanobändern umfasst und wobei das zweite Halbleitergebiet eine Mehrzahl von zweiten Halbleiternanobändern umfasst.

5. Integrierte Schaltung nach Anspruch 4, wobei die Mehrzahl von ersten Halbleiternanobändern und die Mehrzahl von zweiten Halbleiternanobändern Germanium, Silicium oder eine Kombination davon umfassen.

6. Integrierte Schaltung nach einem der Ansprüche 1 bis 5, wobei die erste Gate-Struktur und die zweite Gate-Struktur jeweils ein Gate-Dielektrikum um das erste Halbleitergebiet und das zweite Halbleitergebiet herum und entlang einer Unterseite der ersten Gate-Struktur und der zweiten Gate-Struktur aufweisen.

7. Integrierte Schaltung nach Anspruch 6, wobei das Gate-Dielektrikum Hafnium und Sauerstoff umfasst.

8. Integrierte Schaltung nach Anspruch 6 oder 7, wobei die leitfähige Struktur (120, 1302, 1502) unter der ersten Gate-Struktur und der zweiten Gate-Struktur mit dem Gate-Dielektrikum in einem Kontakt steht.

9. Integrierte Schaltung nach einem der Ansprüche 1 bis 8, wobei die leitfähige Struktur (120, 1302, 1502) ein gleiches leitfähiges Material wie sowohl der erste Kontakt als auch der zweite Kontakt umfasst.

10. Integrierte Schaltung nach einem der Ansprüche 1 bis 9, wobei die leitfähige Struktur (120, 1302, 1502) Wolfram oder Kupfer umfasst.

11. Integrierte Schaltung nach einem der Ansprüche 1 bis 10, wobei die leitfähige Struktur (120, 1302, 1502) zwischen der ersten Gate-Struktur und der zweiten Gate-Struktur mit einer Oberfläche der dielektrischen Wand (116, 802) in einem Kontakt steht.

12. Integrierte Schaltung nach einem der Ansprüche 1 bis 11, wobei eine Unterseite der leitfähigen Struktur (120, 1302, 1502) im Wesentlichen komplanar mit einer Unterseite der dielektrischen Schicht (108, 504, 902) ist.

13. Gedruckte Leiterplatte, welche die integrierte Schaltung nach einem der Ansprüche 1 bis 12 umfasst.

14. Verfahren zum Bilden einer integrierten Schaltung, wobei das Verfahren umfasst:
Bilden einer ersten Finne, die ein erstes Halbleitermaterial umfasst, und einer zweiten Finne, die ein zweites Halbleitermaterial umfasst, wobei sich die erste und zweite Finne über einem Substrat (201) erstrecken und sich jeweils in einer ersten Richtung erstrecken;
Bilden einer Gate-Elektrode (112, 704), die sich über dem ersten Halbleitermaterial und dem zweiten Halbleitermaterial in einer zweiten Richtung erstreckt, die verschieden von der ersten Richtung ist;
Bilden eines ersten Source- oder Drain-Gebiets an einem ersten Ende der ersten Finne;
Bilden eines zweiten Source- oder Drain-Gebiets an einem ersten Ende der zweiten Finne;
Bilden eines Kontakts über dem ersten Source- oder Drain-Gebiet und dem zweiten Source- oder Drain-Gebiet;
Bilden einer Vertiefung durch die Gate-Elektrode (112, 704) zwischen der ersten Finne und der zweiten Finne, wobei sich die Vertiefung zwischen dem ersten Source- oder Drain-Gebiet und dem zweiten Source- oder Drain-Gebiet weiter in der ersten Richtung erstreckt, wobei die Vertiefung die Gate-Elektrode (112, 704) in eine erste Gate-Elektrode und eine zweite Gate-Elektrode aufteilt und den Kontakt in einen ersten Kontakt und einen zweiten Kontakt aufteilt;
Bilden einer dielektrischen Wand (116, 802) innerhalb der Vertiefung;
Entfernen des Substrats (201) und Bilden einer dielektrischen Schicht (108, 504, 902) unter der ersten Gate-Elektrode und der zweiten Gate-Elektrode;
Vertiefen eines Abschnitts der dielektrischen Wand (116, 802) von einer Rückseite der integrierten Schaltung, sodass sich eine Oberseite der vertieften dielektrischen Wand (116, 802) zwischen der ersten Gate-Elektrode und der zweiten Gate-Elektrode befindet;
Entfernen von freiliegenden Abschnitten des ersten Source- oder Drain-Gebiets und des zweiten Source- oder Drain-Gebiets von der Rückseite der integrierten Schaltung, sodass Abschnitte von einem oder beiden des ersten Kontakts und des zweiten Kontakts von der Rückseite her freiliegen; und
Bilden einer leitfähigen Struktur (120, 1302, 1502) innerhalb eines vertieften Bereichs von der Rückseite, sodass die leitfähige Struktur (120, 1302, 1502) mit einem oder beiden des ersten Kontakts und des zweiten Kontakts in einem Kontakt steht.

15. Verfahren nach Anspruch 14, wobei das Vertiefen des Abschnitts der dielektrischen Wand (116, 802) ferner ein Vertiefen einer vollständigen Dicke eines Abschnitts der dielektrischen Schicht (108, 504, 902) umfasst.

## Revendications

1. Circuit intégré comprenant :
une première région semi-conductrice s'étendant dans une première direction à partir d'une première région de source ou de drain ;
une deuxième région semi-conductrice s'étendant dans la première direction depuis une deuxième région de source ou de drain, la deuxième région de source ou de drain étant espacée de la première région de source ou de drain dans une deuxième direction différente de la première direction ;
une première structure de grille autour de la première région semi-conductrice et une deuxième structure de grille autour de la deuxième région semi-conductrice ;
une couche de diélectrique (108, 504, 902) sous la première structure de grille et la deuxième structure de grille ;
une paroi diélectrique (116, 802) entre la première région semi-conductrice et la deuxième région semi-conductrice et s'étendant dans la première direction de sorte que la paroi diélectrique (116, 802) s'étende entre la première structure de grille et la deuxième structure de grille ;
un premier contact sur une surface supérieure de la première région de source ou de drain et un deuxième contact sur une surface supérieure de la deuxième région de source ou de drain ; et
une structure conductrice (120, 1302, 1502) s'étendant à travers toute l'épaisseur de la couche diélectrique (108, 504, 902) et le long de toute l'épaisseur de la première région de source ou de drain et de la deuxième région de source ou de drain pour venir en contact avec le premier contact et/ou le deuxième contact, où une partie de la structure conductrice (120, 1302, 1502) s'étend également dans la première direction entre la première structure de grille et la deuxième structure de grille.

2. Circuit intégré selon la revendication 1, dans lequel la couche diélectrique (108, 504, 902) est une première couche diélectrique, et la paroi diélectrique (116, 802) comprend une deuxième couche diélectrique le long d'un ou plusieurs bords de la paroi diélectrique (116, 802) et un remplissage diélectrique (306, 506, 1504) dans un volume restant de la paroi diélectrique (116, 802).

3. Circuit intégré selon la revendication 2, dans lequel la deuxième couche diélectrique comprend un matériau diélectrique à faible constante diélectrique.

4. Circuit intégré selon l'une quelconque des revendications 1 à 3, dans lequel la première région semi-conductrice comprend une pluralité de premiers nanorubans semi-conducteurs et la deuxième région semi-conductrice comprend une pluralité de deuxièmes nanorubans semi-conducteurs.

5. Circuit intégré selon la revendication 4, dans lequel la pluralité de premiers nanorubans semi-conducteurs et la pluralité de deuxièmes nanorubans semi-conducteurs comprennent du germanium, du silicium, ou une combinaison de ceux-ci.

6. Circuit intégré selon l'une quelconque des revendications 1 à 5, dans lequel la première structure de grille et la deuxième structure de grille comprennent chacune un diélectrique de grille autour de la première région semi-conductrice et de la deuxième région semi-conductrice et le long d'une surface inférieure de la première structure de grille et de la deuxième structure de grille.

7. Structure de circuit intégré selon la revendication 6, dans laquelle le diélectrique de grille comprend de l'hafnium et de l'oxygène.

8. Circuit intégré selon la revendication 6 ou la revendication 7, dans lequel la structure conductrice (120, 1302, 1502) est en contact avec le diélectrique de grille sous la première structure de grille et la deuxième structure de grille.

9. Circuit intégré selon l'une quelconque des revendications 1 à 8, dans lequel la structure conductrice (120, 1302, 1502) comprend un même matériau conducteur que le premier contact et le deuxième contact.

10. Circuit intégré selon l'une quelconque des revendications 1 à 9, dans lequel la structure conductrice (120, 1302, 1502) comprend du tungstène ou du cuivre.

11. Circuit intégré selon l'une quelconque des revendications 1 à 10, dans lequel la structure conductrice (120, 1302, 1502) est en contact avec une surface de la paroi diélectrique (116, 802) entre la première structure de grille et la deuxième structure de grille.

12. Circuit intégré selon l'une quelconque des revendications 1 à 11, dans lequel une surface inférieure de la structure conductrice (120, 1302, 1502) est sensiblement coplanaire avec une surface inférieure de la couche diélectrique (108, 504, 902).

13. Carte de circuit imprimé comprenant le circuit intégré selon l'une quelconque des revendications 1 à 12.

14. Procédé de formation d'un circuit intégré, le procédé comportant les étapes suivantes :
former une première ailette comprenant un premier matériau semi-conducteur et une deuxième ailette comprenant un deuxième matériau semi-conducteur, les première et deuxième ailettes s'étendant au-dessus d'un substrat (201) et chacune s'étendant selon une première direction ;
former une électrode de grille (112, 704) s'étendant sur le premier matériau semi-conducteur et le deuxième matériau semi-conducteur selon une deuxième direction différente de la première direction ;
former une première région de source ou de drain au niveau d'une première extrémité de la première ailette ;
former une deuxième région de source ou de drain au niveau d'une première extrémité de la deuxième ailette ;
former un contact sur la première région de source ou de drain et la deuxième région de source ou de drain ;
former un renfoncement à travers l'électrode de grille (112, 704) entre la première ailette et la deuxième ailette, le renfoncement s'étendant en outre dans la première direction entre la première région de source ou de drain et la deuxième région de source ou de drain, le renfoncement divisant l'électrode de grille (112, 704) en une première électrode de grille et une deuxième électrode de grille et divisant le contact en un premier contact et un deuxième contact ;
former une paroi diélectrique (116, 802) au sein du renfoncement ;
retirer le substrat (201) et former une couche de diélectrique (108, 504, 902) sous la première électrode de grille et la deuxième électrode de grille ;
évider une partie de la paroi diélectrique (116, 802) depuis une face arrière du circuit intégré, de telle sorte qu'une surface supérieure de la paroi diélectrique évidée (116, 802) se trouve entre la première électrode de grille et la deuxième électrode de grille ;
retirer les parties exposées de la première région de source ou de drain et de la deuxième région de source ou de drain de la face arrière du circuit intégré de façon à ce que des parties de l'un ou des deux des premier et deuxième contacts soient exposées depuis la face arrière ; et
former une structure conductrice (120, 1302, 1502) dans une zone évidée à partir de la face arrière de telle sorte que la structure conductrice (120, 1302, 1502) soit en contact avec le premier contact et/ou le deuxième contact.

15. Procédé selon la revendication 14, dans lequel le renfoncement de la partie de la paroi diélectrique (116, 802) comprend en outre d'évider une épaisseur entière d'une partie de la couche diélectrique (108, 504, 902).
